(19) Europäisches Patentamt
European Patent Office
Office européen des brevets

(11) EP 2 271 897 B1

(12) **EUROPÄISCHE PATENTSCHRIFT**

(45) Veröffentlichungstag und Bekanntmachung des Hinweises auf die Patenterteilung:
**06.07.2016 Patentblatt 2016/27**

(21) Anmeldenummer: **09734526.8**

(22) Anmeldetag: **12.03.2009**

(51) Int Cl.:
***G01D 5/249*** *(2006.01)* ***H03M 1/28*** *(2006.01)*

(86) Internationale Anmeldenummer:
**PCT/EP2009/001768**

(87) Internationale Veröffentlichungsnummer:
**WO 2009/129891 (29.10.2009 Gazette 2009/44)**

(54) **WINKELMESSEINRICHTUNG UND BAUREIHE MIT DERARTIGEN WINKELMESSEINRICHTUNGEN**

ANGLE-MEASURING DEVICE AND LINE OF PRODUCTS COMPRISING SAID ANGLE-MEASURING DEVICES

DISPOSITIF DE MESURE ANGULAIRE ET SÉRIE COMPORTANT CE DISPOSITIF

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**

(30) Priorität: **23.04.2008 DE 102008020110**

(43) Veröffentlichungstag der Anmeldung:
**12.01.2011 Patentblatt 2011/02**

(73) Patentinhaber: **Dr. Johannes Heidenhain GmbH**
**83301 Traunreut (DE)**

(72) Erfinder:
- **MAYER, Elmar**
  **83365 Nussdorf (DE)**
- **SCHÜRMANN, Thomas**
  **83026 Rosenheim (DE)**
- **LINGK, Christoph**
  **83278 Traunstein (DE)**

(56) Entgegenhaltungen:
**DE-A1- 3 829 545 JP-A- 2005 061 907**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 2 271 897 B1

## Beschreibung

Die Erfindung betrifft eine Winkelmesseinrichtung mit einer Abtasteinrichtung zur Abtastung eines seriellen Codes und zur Ausgabe von decodierten Wörtern als Position gemäß dem Patentanspruch 1.

Weiterhin betrifft die Erfindung eine Baureihe von Winkelmesseinrichtungen gemäß dem Patentanspruch 9.

Auf vielen Gebieten werden zur Bestimmung der Position zweier zueinander bewegter Körper vermehrt absolute Winkelmesseinrichtungen eingesetzt. Absolute Winkelmesseinrichtungen haben gegenüber rein inkremental messenden Systemen den Vorteil, dass in jeder Relativlage auch nach Unterbrechung der Versorgungsenergie sofort eine korrekte Positionsinformation ausgegeben werden kann.

Die absolute Position wird dabei von einem Code verkörpert. Besonders Platz sparend ist die Anordnung der Positionsinformation in einer einzigen Codespur mit in Messrichtung hintereinander angeordneten Codeelementen. Die Codeelemente sind dabei in pseudozufälliger Verteilung hintereinander angeordnet, so dass eine bestimmte Anzahl von aufeinander folgenden Codeelementen jeweils ein Codewort bildet, das die absolute Position eindeutig definiert. Bei der Verschiebung der Abtasteinrichtung um ein einziges Codeelement wird bereits ein neues Codewort gebildet und über den gesamten absolut zu erfassenden Umfang steht eine Folge von unterschiedlichen Codewörtern zur Verfügung. Ein derartiger serieller bzw. sequentieller Code wird auch oft als Kettencode oder als Pseudo-Random-Code bezeichnet.

Wie beispielsweise in der JP 57-175211 A erläutert ist, wird zur Bestimmung der absoluten Position aus den abgetasteten Codewörtern - auch Decodierung genannt - eine Decodiertabelle (look-up-table) eingesetzt, in der jedem Codewort eine Position zugeordnet ist. Zur Zuordnung der absoluten Position zu einem abgetasteten Codewort bildet das Codewort die Adresse für die Decodiertabelle, so dass am Ausgang die für dieses Codewort abgelegte absolute Position ansteht und zur Weiterverarbeitung zur Verfügung steht.

Diese nichtflüchtigen Tabellen können heute in einem ASIC hardwareverdrahtet ausgelegt sein, um einen schnellen Zugriff zu ermöglichen. Um ASIC's kostengünstig zu beziehen, sind aber relativ hohe Stückzahlen pro ASIC erforderlich. Ziel ist es deshalb, die Variantenvielfalt zu minimieren. Die Grenzen der Reduzierung von Varianten ist insbesondere bei Winkelmesseinrichtungen erreicht, bei denen über den gesamten Umfang in jeder Winkellage eine eindeutige absolute Position ausgegeben werden soll. Vom Kunden werden unterschiedliche Durchmesser der Winkelmesseinrichtungen mit einer unterschiedlichen Anzahl von absoluten Positionen pro Umdrehung gefordert. In der Regel wird hierzu für jeden Durchmesser ein separater ASIC mit einer individuellen Tabelle angepasst an den individuellen Code verwendet.

Um eine Abtasteinrichtung für verschiedene Durchmesser einer Codescheibe, also für verschiedene Varianten einer Winkelmesseinrichtung, verwenden zu können, wird in der JP 2005-061907 A vorgeschlagen, in der Abtasteinrichtung für mehrere Varianten jeweils eine individuelle Decodiertabelle in Form von Read-Only-Memories (ROM) mit einem vollständigen Wertevorrat von allen zu dekodierenden Codewörtern vorzusehen. Aufgrund einer Kennung in Form eines Auswahlsignals, welches den abzutastenden Code spezifiziert, werden bei der Decodierung nur Daten der diesem Code individuell zugeordneten Decodiertabelle verwendet. Bei der Auswahl der Codes wird von einer generierten Folge von eindeutigen Codewörtern ausgegangen. Für Winkelmesseinrichtungen kleineren Durchmessers, also kürzerer Codelänge, ist eine vollständige separate Decodiertabelle vorhanden, deren Codewörter ein ausgewählter Teil der vorhandenen Folge von Codewörtern ist. Der Nachteil dieser Winkelmesseinrichtung ist, dass für die Decodiertabellen und somit für den Code nur ganz spezielle Folgen aus der generierten Folge von Codewörtern auswählbar sind, und dass die Hamming-Distanz der Codewörter der Folgen zwangsläufig 1 ist. Darüber hinaus ist der Platzbedarf für die mehreren vollständigen Decodiertabellen relativ groß.

Aufgabe der Erfindung ist es daher, eine Winkelmesseinrichtung anzuheben, mit der eine Standardisierung zum Aufbau einer Baureihe von Winkelmesseinrichtungen auf einfache Weise ermöglicht wird.

Diese Aufgabe wird durch die im Anspruches 1 angegebene Winkelmesseinrichtung und mit der im Anspruch 9 angegebenen Baureihe von Winkelmesseinrichtungen gelöst.

Bei der Erfindung wird zum Erreichen einer Standardisierung nicht von einer einzigen Folge von Codewörtern ausgegangen, sondern es wird von einem gemeinsamen Code ausgegangen. Der Erfindung liegt somit die Erkenntnis zugrunde, dass bereits durch die Verwendung eines gemeinsamen Codes eine Standardisierung mit einfachen Maßnahmen erreichbar ist. Die bei der Abtastung des gemeinsamen Codes generierte Folge von Codewörtern kann mittels eines gemeinsamen Wertevorrats, nachfolgend erster Wertevorrat genannt, decodiert werden. Die bei der Abtastung generierten vollständigen Folgen von Codewörtern zweier Winkelmesseinrichtungen der durch die Standardisierung gebildeten Baureihe unterscheiden sich aber in den restlichen Bereichen (erste Teilfolge und zweite Teilfolge). Es ist somit möglich, aus einem langen Code einer Winkelmesseinrichtung großen Durchmessers einen Teil dieses Codes für einen kleinen Code einer Winkelmesseinrichtung kleineren Durchmessers zu übernehmen. Die beiden Folgen von Codewörtern, die bei der Abtastung des langen Codes und des kürzeren Codes entstehen, enthalten nun einen gemeinsamen Folgeteil, entstanden aus dem gemeinsamen Codeteil. Die Folge von Codewörtern, die durch Abtastung des geschlossenen langen Codes entsteht, enthält darüber hinaus einen weiteren Folgeteil (erste Teilfolge), der mittels eines zweiten Wertevorrates decodierbar ist. Da der Code der Winkelmesseinrichtung mit dem kleinen Durchmessers dem gemeinsamen Codeteil entspricht, entstehen bei der Abtastung nur am zyklisch fortgesetzten Bereich, also am Stoß oder Überlapp, neue Codewörter (zweite Teilfolge). Zur Codierung dieser relativ wenigen neuen Codewörter ist nun ein individueller Wertevorrat zur Decodierung vorgesehen, der als dritter Wertevorrat abgespeichert ist.

Durch diese Maßnahme ist es nun möglich, ausgehend von einem Code, auf einfache Weise eine Standardisierung von Winkelmesseinrichtungen zu erreichen. Darüber hinaus ist es auch einfach möglich, einen Code und eine Abtastlänge zu wählen, damit alle zu decodierenden Codewörter der Folgen eine Hamming-Distanz größer 1 haben, was eine Fehleraufdeckung und ggf. Korrektur der Codewörter erlaubt und somit eine sichere Positionsermittlung gewährleistet.

Vorteilhafte Ausgestaltungen der Erfindung sind in den abhängigen Ansprüchen angegeben.

Die Erfindung wird anhand der Zeichnungen näher erläutert, dabei zeigen:

Figur 1 eine erste Winkelmesseinrichtung in schematischer Darstellung;

Figur 2 eine zweite Winkelmesseinrichtung in schematischer Darstellung;

Figur 3 eine Abtasteinrichtung der ersten und zweiten Winkelmesseinrichtungen gemäß den Figuren 1 und 2 im Detail;

Figur 4 ein Flussdiagramm zur Positionsmesswertermittlung einer ersten Abtasteinrichtung für die erste und zweite Codescheibe;

Figur 5 ein Flussdiagramm zur Positionsmesswertermittlung einer zweiten Abtasteinrichtung für die erste und zweite Codescheibe;

Figur 6 einen seriellen Code von vier weiteren Codescheiben;

Figur 7 ein Flussdiagramm zur Positionsmesswertermittlung einer Abtasteinrichtung für den Code der vier Codescheiben gemäß Figur 6;

Figur 8 ein weiteres Flussdiagramm zur Positionsmesswertermittlung einer Abtasteinrichtung für den Code der vier Codescheiben gemäß der Figur 6;

Figur 9 einen Code sowie eine mögliche Aufteilung in mehrere Tabellen;

Figur 10 ein Flussdiagramm zur Positionsmesswertermittlung für den in Figur 9 dargestellten Code;

Figur 11 ein Flussdiagramm zur Positionsmesswertermittlung in allgemeiner Form und

Figur 12 ein weiteres Flussdiagramm zur Positionsmesswertermittlung in allgemeiner Form.

Grundlagen:

In Figur 1 ist eine erste Winkelmesseinrichtung schematisch dargestellt. Diese Winkelmesseinrichtung arbeitet beispielsweise nach dem optischen Abtastprinzip, bei dem ein serieller Code C1 einer Codescheibe im Durchlichtverfahren oder Auflichtverfahren abgetastet wird. Der serielle Code C1 besteht aus einer hintereinander angeordneten Folge von gleich langen Codeelementen A, hier mit den Indizes 0 bis 19 durchnummeriert.

Der serielle Code C1, auch sequentieller Code bezeichnet, wird von einer Lichtquelle beleuchtet, deren Licht mehrere aufeinander folgende Codeelemente A gleichzeitig beleuchtet. Das Licht wird von dem Code C1 positionsabhängig moduliert, so dass am Ort einer Detektoranordnung 10 eine positionsabhängige Lichtverteilung entsteht, die von der Detektoranordnung 10 einer Abtasteinrichtung 20 in positionsabhängige elektrische Abtastsignale B1 bis B5 gewandelt wird.

Die Detektoranordnung 10 ist ein Zeilensensor mit einer in Messrichtung angeordneten Folge von Detektorelementen 10.1 bis 10.5. Jedem der Codeelemente A ist in jeder Relativlage zumindest eines der Detektorelemente 10.1 bis 10.5 eindeutig zugeordnet, so dass in jeder Relativlage der Detektoranordnung 10 gegenüber dem Code C1 jeweils ein eindeutiges Abtastsignal B1 bis B5 aus jedem der Codeelemente A gewonnen wird. Die Abfolge der Abtastsignale B1 bis B5 bildet jeweils ein Codewort W, wobei die Anzahl der Codeelemente A, aus der jeweils ein Wort W zusammengesetzt ist, als Abtastlänge $L_A$ definiert ist. Die Abtastsignale B1 bis B5, also das Codewort W, werden einer Decodiereinrichtung 30 der Abtasteinrichtung 20 zugeführt, welche daraus eine absolute Position POS ableitet. Bei einer Verschiebung der Detektoranordnung 10 gegenüber dem Code C1 um die Breite bzw. Länge eines Codeelementes A wird ein neues Codewort W erzeugt und über den absolut zu vermessenden Messbereich wird eine Vielzahl von unterschiedlichen Codewörtern W gebildet. Diese unterschiedlichen Codewörter W sind in den später noch weiter erläuterten Tabellen mit Indizes 0 bis 1058 versehen.

Wie in Figur 1 schematisch dargestellt ist, werden zur Bestimmung der absoluten Position POS die Codewörter W der Decodiereinrichtung 30 zugeführt, in der die zu decodierenden Codewörter W abgespeichert sind. Zu jedem dieser Codewörter W ist wiederum eine absolute Position POS abgespeichert und somit eindeutig zugeordnet. Die abgespeicherte Folge von Codewörtern W entspricht dabei der durch Abtastung des Codes C1 bei korrekter Betriebsweise erzeugbaren Folge von Codewörtern W. Die Decodiereinrichtung 30 enthält somit einen Wertevorrat, der die Zuordnung Codewort W zu Position POS definiert. Dieser Wertevorrat ist in einer Zuordnungstabelle, nachfolgend nur noch Tabelle genannt, abgespeichert, in der die Zuordnung Codewort W zu Position POS abgelegt ist. Zur Zuordnung der absoluten Position POS zu einem abgetasteten Codewort W, also zur Decodierung, bildet das Codewort W die Adresse für die Zuordnungstabelle, so dass am Ausgang die dieser Adresse zugeordnete Position POS ansteht. Diese Decodierung ist erforderlich, um die Ausgabe zu standardisieren. Die gebräuchlichste Decodierung ist die Umwandlung in eine Binärcodierung.

Die Erfindung wird anhand von verschiedenen Winkelmesseinrichtungen nachfolgend weiter erläutert. Dabei kann der Code C1 sich auf einem Codeträger in Form einer Codescheibe oder auf einer Umfangsfläche einer Trommel befinden.

Gegeben sei gemäß Figur 1 ein serieller Code C1 der Länge $L_1$, wobei $L_1$ ganzzahlig ist, aber nicht notwendig gleich einer Zweierpotenz ($2^n$ oder $2^n$-1 mit n ganzzahlig und $n \geq 2$) sein muss. Die Abtastung dieses seriellen Codes C1 erfolgt mittels der Detektorelemente 10.1 bis 10.5 der Detektoranordnung 10. Diese Detektoranordnung 10 tastet eine bestimmte Anzahl von Codeelementen A ab und generiert daraus eine Bitfolge, die das Codewort W darstellt. Die Anzahl der Codeelemente A, aus der das Codewort W gebildet ist, wird Abtastlänge $L_A$. genannt. Jede Stellung der Codescheibe mit dem Code C1 der Winkelmesseinrichtung ist durch ein Codesegment, bestehend aus $L_A$ Codeelementen A, eindeutig codiert, und zwar über den gesamten absolut zu erfassenden Messbereich, dem Umfang.

Der serielle Code C1 sei hier durch eine Folge von Codeelementen $A_i$ gegeben, wobei $A_i \in \{0;1\}$ und $i=0...(L_1-1)$.

$$\left| A_0A_1A_2A_3 \ldots\ldots\ldots A_{L1-3}A_{L1-2}A_{L1-1} \right| A_0A_1A_2A_3.$$

Länge: $L_1$

Der serielle Code C1 ist geschlossen oder zyklisch fortgesetzt; das heißt, dass am Ende der Folge von Codeelementen A der Anfang der Folge von Codeelementen A angehängt ist. Ein solches System beschreibt damit insbesondere beliebige serielle Codes für rotatorische Systeme. "Überlapp" heißt in diesem Zusammenhang der Übergang vom Codeende wieder zum Codeanfang, also der Übergang am Stoß, gemäß des in Figur 1 gezeigten Beispiels ist dies der Stoß ST1. Der Überlapp wird vom zyklisch fortgesetzten Bereich des Codes C1 gebildet. So ergibt sich bei einer kreisförmigen Anordnung des Codes C1 bei jeder Stellung eine eindeutige Nachfolgeposition zu einer vorangegangenen Position.

Zur Decodierung in der Decodiereinrichtung 30 wird ein Speicher benutzt, der hardwareverdrahtet ausgeführt ist, dabei ist die Decodiereinrichtung 30 als ASIC ausgebildet, wobei die Tabellen, also die Speicher für den erforderlichen Wertevorrat, jeweils bei der Fertigung des Chips fest verdrahtet ausgebildet sind, insbesondere als Logikstruktur. An den Eingangsleitungen liegen die von der Detektoranordnung 10 kommenden digitalisierten Abtastsignale B1 bis B5, also das aktuelle Codewort W, als Bitmuster (Bitpattern) an. Am Ausgang steht dann die entsprechende Position POS in digitalisierter Form an. Vorteil einer solchen hardwareverdrahteten Tabelle ist, dass die Positionsinformation innerhalb eines Zeitschritts der digitalen Hardware entschlüsselt werden kann. Allgemein kann man in obiger Notation die Tabelle gemäß der im Anhang dargestellten Tabelle 1. aufschreiben.

Die Position (dritte Spalte der Tabelle 1) sei mit $POS_i$ bezeichnet, wobei $i=0...(L_1-1)$. Dann lässt sich die Decodierung mittels einer Operatorschreibweise darstellen. Es gilt:

$$POS_i=T(w_i) \text{ mit } i=0... (L_1-1).$$

Das Zahlenbeispiel gemäß der ersten Winkelmesseinrichtung gemäß Figur 1:

$$L_1=20;\ L_A=5$$

Serieller Code:

$$|A_0A_1A_2A_3A_4A_5A_6A_7A_8A_9A_{10}A_{11}A_{12}A_{13}A_{14}A_{15}A_{16}A_{17}A_{18}A_{19}|A_0A_1A_2A_3A_4A_5A_6.$$

Länge: $L_1$=20

Für dieses spezielle Zahlenbeispiel ist die Tabelle 2 als Decodiertabelle mit dem darin dargestellten Wertevorrat vorgesehen.

Für die erste Winkelmesseinrichtung, im folgenden "großes Gerät" genannt, wird nun der Code C1 mit $L_1$ seriellen Bits auf dem Umfang der Codescheibe benötigt (Figur 1).

Für eine zweite in Figur 2 dargestellte Winkelmesseinrichtung, im folgenden "kleines Gerät" genannt, wird ein Code C2 mit einer Zahl $L_2$ serieller Bits benötigt. Es gilt $L_2<L_1$. Die Abtastlänge sei wieder $L_A$. In dieser allgemeinen Notation ist zu bemerken, dass alle Indizes immer modulo $L_1$ genommen werden müssen. Unter der Voraussetzung, dass die Codeelemente A beim Code C1 und beim Code C2 in Messrichtung jeweils gleiche Längen aufweisen, hat der Codeträger (Scheibe oder Trommel) für den Code C1 einen größeren Durchmesser als der Codeträger für den Code C2, weshalb nachfolgend die Begriffe "kleines Gerät" und "großes Gerät" verwendet werden.

Der serielle Code C2 für das "kleine Gerät" ist ein Ausschnitt (in Figur 1 mit V bezeichnet) des seriellen Codes C1 des "großen Geräts":

Länge: $L_2$

$$A_0A_1A_2A_3\ldots A_{S2-1}A_{S2}A_{S2+1}\ldots A_{S2+L2-2}A_{S2+L2-1}A_{S2+L2}\ldots\ldots A_{L1-3}A_{L1-2}A_{L1-1}A_0A_1A_2A_3.$$

Länge: $L_1$

Die Decodiertabelle für das "kleine Gerät" findet sich in allgemeiner Form in Tabelle 3.

Die Decodiertabelle zum Beispiel des Codes C2 des "kleinen Geräts" gemäß Figur 2 findet sich in Tabelle 4, mit:

$L_2$=11 und $L_A$=5

Die Bitfolge des ersten Codes C1 (mit $L_1$=20) und des zweiten Codes C2 (mit $L_2$=11) grafisch dargestellt:

Länge: $L_2$=11

$$A_0A_1A_2A_3A_4A_5A_6A_7A_8A_9A_{10}A_{11}A_{12}A_{13}A_{14}A_{15}A_{16}A_{17}A_{18}A_{19}A_0A_1A_2A_3A_4A_5A_6\ldots$$

Länge: $L_1$=20

Aus dieser Darstellung sowie aus der Tabelle 2 für die erste Folge von Codewörtern W, also dem Code C1, und aus der Tabelle 4 für die zweite Folge von Codewörtern W, also dem Code C2, ist ersichtlich, dass in beiden Tabellen 2 und 4 jeweils gleiche Wörter W vorkommen. Die zweite Folge von Codewörtern W ist gegenüber der ersten Folge von Codewörtern um drei Bits und somit um drei Codewörter W verschoben, so dass in diesem Beispiel $S_2$=3 als Verschiebewert bei der Decodierung zu berücksichtigen ist, wie später noch im Detail erläutert wird. Für beliebige Ausschnitte V fängt der serielle Code C2 des kleinen Gerätes bei der Stelle $S_2$ an, wobei $0 \leq S_2 \leq L_1-1$.

Nach der Tabelle 4 ist eine Gegenüberstellung der vollständigen Tabelle 2 der ersten Winkelmesseinrichtung und der aus dieser Tabelle 2 nutzbare Teil der Tabelle 4 der zweiten Winkelmesseinrichtungen dargestellt. Daraus ist auch die Verschiebung $S_2$=3 der beiden identischen Tabellenteile gegeneinander ersichtlich.

Man sieht, dass die Bitfolgen von ($A_3A_4A_5A_6A_7$) bis ($A_9A_{10}A_{11}A_{12}A_{13}$) in beiden Tabellen 2 und 4 vorkommen. Allgemein gilt, dass bei gegebenem $L_1$, $L_2$, $L_A$ und $S_2$ die Wörter an den Positionen $S_2$...($S_2$+$L_2$-$L_A$) von Tabelle 2 identisch mit den Wörtern an den Positionen 0...($L_2$-$L_A$) von Tabelle 4 sind.

Die oben angeführten Grundlagen gelten für alle nachfolgend weiter erörterten Ausführungsbeispiele.

**Erstes Ausführungsbeispiel:**

Nachfolgend wird nun der Kern der Erfindung weitergehend anhand des oben erläuterten Zahlenbeispiels erläutert. Es wird nochmals darauf hingewiesen, dass zur vereinfachten Beschreibung die Erfindung durchgängig mit Tabellen erläutert wird. Tatsächlich wird damit der in den Tabellen enthaltene zur Decodierung erforderliche Wertevorrat definiert, der in unterschiedlicher Weise in der Decodiereinrichtung 30 abgelegt sein kann.

Der erste Code C1 und der zweite Code C2 weisen also einen gemeinsamen Codeteil V auf.

Die Detektoranordnung 10 ist zur Generierung einer ersten Folge von Codewörtern W der vorgegebenen Abtastlänge $L_A$, bei der Abtastung des geschlossenen ersten Codes C1, ausgelegt. Diese erste Folge besteht aus einer ersten Teilfolge und einer sogenannten gemeinsamen Teilfolge, wobei die gemeinsame Teilfolge bei Abtastung des gemeinsamen Codeteils V entsteht. Die Detektoranordnung 10 ist weiterhin zur Generierung einer zweiten Folge von Codewörtern W der vorgegebenen Abtastlänge $L_A$, bei der Abtastung des geschlossenen zweiten Codes C2, ausgelegt. Diese zweite Folge besteht aus einer zweiten Teilfolge, nachfolgend auch als Wertevorrat der Überlapptabelle bezeichnet, und der gemeinsamen Teilfolge, wobei die gemeinsame Teilfolge bei Abtastung des gemeinsamen Codeteils V entsteht. Der erste Code C1 und der zweite Code C2 sowie die Abtastlänge $L_A$ derart gewählt sind, dass die Codewörter W der ersten Folge sowie die Codewörter W der zweiten Folge eine Hamming-Distanz größer 1 aufweisen.

Die Codes C1, C2 und die Abtastlänge $L_A$ sind bevorzugt auch derart gewählt, dass die zweite Teilfolge nicht Bestandteil der ersten Folge von Codewörtern W ist. Mit Teilfolge ist hier die Gesamtheit der Abfolge von Codewörtern gemeint.

Die Decodiereinrichtung 30 ist dazu ausgelegt, die erste Folge und die zweite Folge von Codewörtern W zu decodieren, indem

die Decodiereinrichtung 30 einen ersten Wertevorrat von aufeinander folgenden Codewörtern W aufweist, der zur Decodierung der Codewörter W der gemeinsamen Teilfolge nutzbar ist, und

die Decodiereinrichtung 30 einen zweiten Wertevorrat von Codewörtern W aufweist, wobei dieser Wertevorrat zur Decodierung der ersten Teilfolge von Codewörtern W nutzbar ist, und

die Decodiereinrichtung 30 einen dritten Wertevorrat von Codewörtern W (Überlapptabelle) aufweist, wobei dieser Wertevorrat zur Decodierung der zweiten Teilfolge von Codewörtern W nutzbar ist.

Durch die Erfindung wird die Vermeidung der vollständigen zweiten Tabelle 4 ermöglicht. Dies geschieht über die Einführung der sogenannten Überlapptabelle zur Decodierung der durch den Stoß - in Figur 2 mit ST2 bezeichnet - neu generierten Codewörter W. Diese Überlapptabelle hat in diesem Zahlenbeispiel die Form der Tabelle 5.

Allgemein gilt für die Überlapptabelle die Tabelle 6.

Die Überlapptabelle hat allgemein $L_A$-1 Einträge, wobei $x_j=T_6(w_j)$

$$\text{mit } j=(L_2-L_A+1)\ldots(L_2-1).$$

Um die Decodiereinrichtung 30 besonders Platz sparend auszugestalten, ist in der Abtasteinrichtung 20 die Tabelle 1 und die als Überlapptabelle bezeichnete Tabelle 6 vorhanden. Der zur Decodierung der gemeinsamen Teilfolge der ersten Folge und der zweiten Folge erforderliche Wertevorrat ist nur einmalig als Überlapptabelle abgespeichert. Die Winkelmesseinrichtungen einer Baureihe greifen zur Decodierung dieser gemeinsamen Teilfolge auf diesen Wertevorrat zu.

Für den hier geschilderten Fall mit zwei Geräten mit unterschiedlichem Umfang und damit mit unterschiedlichen Bitzahlen $L_1$ und $L_2$ gemäß den Figuren 1 bis 2 ergibt sich so das in Figur 4 dargestellte Flussdiagramm.

Die in Figur 3 dargestellte Abtasteinrichtung 20 ist somit zur Abtastung und Auswertung des Codes C1 der Codescheibe gemäß Figur 1 sowie auch zur Abtastung und Auswertung des Codes C2 der Codescheibe gemäß Figur 2 ausgebildet.

Ist die Abtasteinrichtung 30 dem Code C1 zugeordnet, wird der linke Ast des Flussdiagramms gemäß Figur 4 durchlaufen. Das bedeutet, dass die von der Detektoranordnung 10 an die Decodiereinrichtung 30 gelieferten Codeworte W der ersten Folge von Codewörtern W - also des Codes C1 - an der Tabelle 1 anstehen und die dazu abgespeicherte Position POS ausgelesen wird. Hierzu enthält die Tabelle 1 einen vollständigen Wertevorrat von aufeinander folgenden Codewörtern W, die in der zu dekodierenden ersten Folge von Codewörtern W - also des Codes C1 - enthalten sind.

Dieser Wertevorrat der Tabelle 1 umfasst aufeinander folgende Codewörter W, die in der zu dekodierenden ersten Folge von Codewörtern W - also des Codes C1 - enthalten sind sowie in der zu dekodierenden zweiten Folge von Codewörtern W - also des Codes C2 - gemeinsam enthalten sind. Der weitere Wertevorrat der Tabelle 1 von aufeinander folgenden Codewörtern W, ist nur in der zu dekodierenden ersten Folge enthalten. Wird für das abgetastete Codewort W kein Eintrag in der Tabelle 1 gefunden, wird ein Alarm bzw. eine Fehlermeldung ausgegeben.

Ist die Abtasteinrichtung 30 dem Code C2 zugeordnet, wird der rechte Ast des Flussdiagramms durchlaufen. Das bedeutet, dass die von der Detektoranordnung 10 an die Decodiereinrichtung 30 gelieferten Codeworte W der zweiten Folge von Codewörtern W an der Tabelle 1 anstehen sowie an der Tabelle 6 anstehen. Wie bereits erwähnt, enthält die Tabelle 1 einen Wertevorrat von aufeinander folgenden Codewörtern W, die in der zu dekodierenden ersten Folge von Codewörtern W - also dem Code C1 - sowie in der zu dekodierenden zweiten Folge von Codewörtern W - also dem Code C2 - gemeinsam enthalten sind. Die Tabelle 6 (Überlapptabelle) besitzt einen Wertevorrat von aufeinander folgenden Codewörtern W, die nur in der zu dekodierenden zweiten Folge enthalten sind, wobei dieser Wertevorrat zur Dekodierung eines weiteren Teils der zweiten Folge Verwendung findet. Wird für das abgetastete Codewort W kein Eintrag in den entsprechenden Tabellen 1 und 6 gefunden, wird ein Alarm bzw. eine Fehlermeldung ausgegeben.

Bei diesem Ausführungsbeispiel gilt also folgende Bedingung:

(der Wertevorrat zur Decodierung der zweiten Folge) = (eine Teilmenge des Wertevorrats zur Decodierung der ersten Folge zuzüglich des Wertevorrats für den Überlapp)

Dabei ist der Code C2 in seiner Gesamtheit ein Ausschnitt V des Codes C1 und der Wertevorrat für den Überlapp am Stoß ST2 muss nur die $L_A$-1 bei der Abtastung neu generierten Codewörter W umfassen, also $L_A$-1 Einträge.

Das Flussdiagramm in Figur 4 bezieht sich auf den allgemeinsten Fall von Tabellen. Bezogen auf das konkrete Zahlenbeispiel gemäß der Figuren 1 und 2 ist dann als Tabelle 1 im Flussdiagramm die konkrete Tabelle 2 und als Tabelle 6 die konkrete Tabelle 5 zu verwenden.

Anzumerken ist noch, dass es sich bei dem ODER in den Rautensymbolen in diesem Flussdiagramm um ein exclusives ODER handelt.

In der Abtasteinrichtung 20 wird bei der Montage der betreffenden Winkelmesseinrichtung eingespeichert, in welchem der möglichen Geräte (großes oder kleines) sie nun eingebaut ist, welcher Code C1 oder C2 und somit welche Codescheibe der Abtasteinrichtung 20 zugeordnet ist. Diese Einspeicherung ist in Figur 3 schematisch dargestellt, indem der Decodiereinrichtung 30 die Kennung ID vorgegeben, beispielsweise eingegeben wird. Die Kennung ID gibt vor, dass beim großen Gerät (Länge: $L_1$ Bits) dekodierte Positionswerte POS aus der Tabelle 1 (bzw. im konkreten Beispiel aus Tabelle 2) verwendet werden müssen und dass beim kleinen Gerät (Länge: $L_2$ Bits) dekodierte Positionswerte POS sowohl aus der Tabelle 1, da allerdings nur im möglichen Bereich 0...($L_2$-$L_A$), bzw. im konkreten Beispiel aus Tabelle 2, als auch aus der Tabelle 6, bzw. im konkreten Beispiel aus Tabelle 5, verwendet werden müssen.

Die Decodiereinrichtung 30 ist somit in Abhängigkeit der Kennung ID, welche die beiden zu dekodierenden Folgen - also die. Codewörter des Codes C1 und des Codes C2 - voneinander unterscheidbar definiert, in einer ersten oder in einer zweiten Betriebsweise betreibbar. In der ersten Betriebsweise steht der Abtasteinrichtung 20 der Code C1 des "großen Geräts" zur Abtastung zur Verfügung und die durch Abtastung des Codes C1 gewonnenen Folge von Codewörtern W wird von der Decodiereinrichtung 30 decodiert, indem diese erste Folge von Codewörtern W durch die erste Decodiertabelle T2 decodierbar ist. In der zweiten Betriebsweise steht der Abtasteinrichtung 20 der Code C2 des "kleinen Geräts" zur Abtastung zur Verfügung und die durch Abtastung gewonnene Folge von Codewörtern W wird wiederum von der Decodiereinrichtung 30 decodiert, indem ein Teil der zweiten Folge, also der Teil, der durch die Abtastung des Ausschnitts V generiert wird, durch die erste Decodiertabelle T2 und ein weiterer Teil durch die zweite Decodiertabelle T5 decodierbar ist. Hierzu ist eine Auswahleinrichtung 40 (in Figur 3 dargestellt), die in Abhängigkeit der Kennung ID in der ersten Betriebsweise zur Decodierung die erste Decodiertabelle T2 und in der zweiten Betriebsweise zur Decodierung die erste Decodiertabelle T2 und die zweite Decodiertabelle T5, also die Überlapptabelle, zur Verfügung stellt.

Die Organisation der Tabellen erfolgt dabei so, dass der den Überlapp decodierende Wertevorrat separat ansteuerbar und zur Decodierung auswählbar ist.

Bei der Dekodierung ist darüber hinaus ggf. noch die gegenseitige Verschiebung des gemeinsam genutzten Wertevorrats zu berücksichtigen. Dies ist am Ende des rechten Astes des Flussdiagramms in Figur 4 dargestellt. Bei der konkreten Verschiebung von 3 Bits ist zur Dekodierung der zweiten Folge von Codewörtern W mittels des gemeinsamen Wertevorrates aus der Tabelle 2 die aus der Tabelle 2 ermittelte Position POS um 3 zu korrigieren, nämlich POS=POS - 3 oder allgemein POS = POS - $S_2$ Dieser Verschiebewert $S_2$ ist in der Abtasteinrichtung 20 abhängig von der Kennung ID hinterlegt.

Die Positionen, die von der Decodiertabelle T2 ausgegeben werden, die den ersten Wertevorrat enthält, wird also bei einer der beiden Betriebsweisen um den vorgegebenen Wert $S_2$ korrigiert.

Anzumerken ist, dass die Position POS als normierter Wert zu interpretieren ist, das heißt, dass POS die Positionsnummer angibt. Beim "kleinen Gerät" bedeutet beispielsweise POS=2 die zweite Position von 11 möglichen Positionen über einen vorgegebenen Messbereich und beim "großen Gerät" bedeutete POS=2 die zweite Position von 20 möglichen Positionen über einen vorgegebenen Messbereich. Ist der Messbereich eine Umdrehung, also 360°, so gilt beim "kleinen Gerät" POS=2=2x360°/11=65,45° und beim "großen Gerät" POS=2=2x360°/20=36°. Dies ist auch bei den nachfolgenden Ausführungsbeispielen zu berücksichtigen.

Zusammenfassend weist also die Winkelmesseinrichtung gemäß dem ersten Ausführungsbeispiel eine Abtasteinrichtung 20 auf, mit der die Abtastung zumindest eines zyklisch fortgesetzten ersten seriellen Codes C1 sowie die Abtastung zumindest eines zyklisch fortgesetzten zweiten seriellen Codes C2 ermöglicht ist, wobei die seriellen Codes C1, C2 unterschiedliche Längen sowie einen identischen Teil V aufeinanderfolgender Codeelemente A aufweisen. Die Abtasteinrichtung 20 weist hierfür folgende Komponenten auf:

- eine Detektoranordnung 10 zur Generierung einer Folge von Codewörtern W einer vorgegebenen Abtastlänge $L_A$, bei der Abtastung eines der seriellen Codes C1 oder C2;
- eine Decodiereinrichtung 30 zur Decodierung der durch die Abtastung gewonnenen Folge von Codewörtern W und zur Ausgabe von decodierten Wörtern als Position POS, wobei die Decodiereinrichtung 30 dazu ausgelegt ist, die durch Abtastung des zyklisch fortgesetzten ersten seriellen Codes C1 gewonnene erste Folge von Codewörtern W und die durch Abtastung des zyklisch fortgesetzten zweiten seriellen Codes C2 gewonnene zweite Folge von Codewörtern W zu decodieren, wobei

die Decodiereinrichtung 30 einen ersten Wertevorrat von aufeinander folgenden Codewörtern W aufweist; der in zumindest der ersten und der zweiten zu dekodierenden Folge gemeinsam enthalten ist, wobei dieser Wertevorrat jeweils zur Decodierung der Codewörter W nutzbar ist, die bei der Abtastung des identischen Teils V des ersten seriellen Codes C1 und des zweiten seriellen Codes C2 gewonnen werden.

Vorteilhaft ist, wie anhand des obigen Zahlenbeispiels erläutert, wenn

- die Decodiereinrichtung 30 zumindest einen zweiten Wertevorrat von Codewörtern W aufweist, wobei dieser Wertevorrat zur Decodierung eines weiteren Teils (erste Teilfolge) der ersten Folge von Codewörtern W nutzbar ist, und
- die Decodiereinrichtung 30 zumindest einen dritten Wertevorrat von Codewörtern W aufweist, wobei dieser Wertevorrat zur Decodierung eines weiteren Teils (dritte Teilfolge) der zweiten Folge von Codewörtern W nutzbar ist.

Dabei ist es weiter vorteilhaft, wenn

- der zweite serielle Code C2 vollständig von dem identischen Teil V gebildet ist, wobei der dritte Wertevorrat eine Anzahl $L_A$ -1 Codewörter W aufweist, die bei der Abtastung über den Stoß ST2 des zyklisch fortgesetzten seriellen zweiten Codes C2 als Überlapp neu generiert werden.

Weiter vorteilhaft ist, wenn

- die Decodiereinrichtung 30 in Abhängigkeit einer Kennung ID, welche die zu dekodierenden Folgen von Codewörtern W voneinander unterscheidbar definiert, in einer ersten oder in einer zweiten Betriebsweise betreibbar ist, wobei in der ersten Betriebsweise die erste Folge von Codewörtern W durch den ersten Wertevorrat und den zweiten Wertevorrat decodierbar ist und in der zweiten Betriebsweise die zweite Folge von Codewörtern W durch den ersten Wertevorrat und den dritten Wertevorrat decodierbar ist.

Hierzu ist es sinnvoll, wenn der den Überlapp decodierende Wertevorrat separat ansteuerbar und zur Decodierung auswählbar ist

Diese Ausführungsform, dass die große Tabelle 2 den gesamten Wertevorrat des "großen Gerätes" beinhaltet und davon nur ein Teil auch zur Decodierung des "kleinen Gerätes" genutzt wird, ist bei der Generierung des seriellen Codes für beide Geräte von besonderem Vorteil. Es braucht nur einmal ein Code C1 für das "große Gerät" optimiert werden, und für das "kleine Gerät" wird dann der Ausschnitt V dieses optimierten Codes C1 verwendet und am Stoß ST2 zusammengefügt. Als einzige Anpassung muss nur die am Stoß neu hinzugekommene "Überlapp"-Tabelle T5 geschaffen werden, mit ($L_A$-1) Einträgen. Voraussetzung für diese besonders vorteilhafte Maßnahme ist, dass der zweite Code C2 vollständig von dem Ausschnitt V des ersten Codes C1 gebildet wird.

Der Code C1, der Ausschnitt V und die Abtastlänge $L_A$ sind dabei derart optimiert, dass alle bei der Abtastung generierten Codewörter W des großen und des kleinen Geräts eine Hamming-Distanz größer als 1 aufweisen.

Um dies zu erreichen, ist die zweite Teilfolge von Codewörtern W in vorteilhafter Weise nicht Bestandteil der ersten Folge von Codewörtern W.

Ein Beispiel eines derartigen Codes C1 mit Hamming-Distanz = 2 mit

$L_1$ : Länge des Codes = 20 (großes Gerät)
$L_A$ : Abtastlänge = 7
Bitfolge: 10101100110000110110

Die entsprechende Decodiertabelle ist die Tabelle 21.

Aus diesem Code C1 lässt sich der Code C2 eines kleinen Geräts herleiten, indem beispielsweise der Ausschnitt V, bestehend aus den ersten 11 Bits des Codes C1, übernommen wird:

$L_2$ : Länge des Codes = 11
$L_A$ : Abtastlänge = 7
Bitfolge: 10101100110

Die entsprechende Decodiertabelle ist die Tabelle 22.

Zweites Ausführungsbeispiel:

Nachfolgend wird eine alternative Ausgestaltung erläutert, die vorteilhaft ist, wenn man das Anlegen von einer großen Tabelle auf einem ASIC verhindern will. Diese alternative Lösung arbeitet mit kleineren Tabellen. Am deutlichsten ist dies wieder in dem Ausführungsbeispiel mit den beiden Codes C1 und C2 zu sehen.

Gegeben sei wieder ein serieller Code C1 mit $L_1$=20 und $L_A$=5. Es sei weiterhin $L_2$=11 und $S_2$=3. Der serielle Code C1 ist dann:

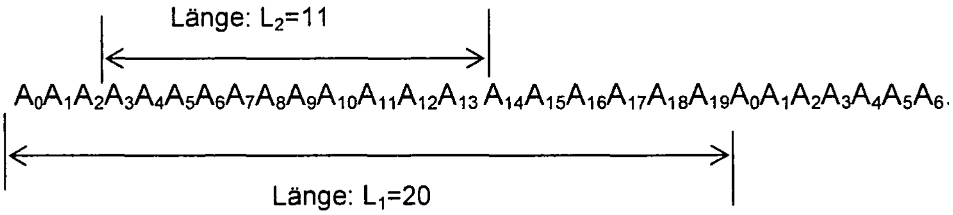


Man zerlegt nun die erste Folge von Codewörtern, also die Tabelle 2 in drei Tabellen, nämlich in die Tabelle 7, die Tabelle 8 und die Tabelle 9 ($T_{N1}$-$T_{N3}$) und generiert wieder die Überlapptabelle Tabelle 6 ($T_6$) mit der zweiten Teilfolge als Wertevorrat, wie beim ersten Ausführungsbeispiel. Der in der Tabelle 7 und der in der Tabelle 9 gespeicherte Wertevorrat repräsentiert die erste Teilfolge der ersten Folge und die Tabelle 8 die gemeinsame Teilfolge.

Das zugehörige Flussdiagramm ist in Figur 5 dargestellt.

In diesem Fall erfolgt die Decodierung des Bitmusters beim großen Gerät anhand der drei Tabellen 7, 8 und 9 ($T_{N1}$, $T_{N2}$, und $T_{N3}$). Beim kleinen Gerät muss sowohl in der kleinen Tabelle 8 ($T_{N2}$) als auch in der Tabelle 6 ($T_6$) gesucht werden. Im Fall "kleines Gerät" ist außerdem die gegenseitige Verschiebung der Tabellen zu berücksichtigen, so dass von POS noch der Wert $S_2$ (im obigen Beispiel: $S_2$=3) abgezogen wird, falls POS in $T_{N2}$ gefunden wurde.

Prinzipiell ist dies das gleiche wie im ersten Ausführungsbeispiel, weil die Tabellen $T_{N1}$, $T_{N2}$ und $T_{N3}$ die gleiche Information beinhalten wie $T_2$. Allerdings bietet diese Möglichkeit zwei Vorteile:

Es ist leichter, kleine Tabellen für einen ASIC zu synthetisieren als große.
Mehrere kleine Tabellen lassen sich bequemer auf einem ASIC "verstauen".

Zu beachten ist wieder, dass es sich bei dem ODER in den Rautensymbolen in diesem Flussdiagramm um ein exclusives ODER handelt.

Die Decodiereinrichtung 30 weist also mehrere Decodiertabellen (Tabelle 5, Tabelle 8 und Tabellen 7 und 9) auf, wobei eine Decodiertabelle (Tabelle 8) den gemeinsam genutzten Wertevorrat der gemeinsamen Teilfolge aufweist. Eine weitere Decodiertabelle (Tabelle 5) den restlichen individuellen Wertevorrat der zweiten Teilfolge des "kleinen Geräts" und eine weitere Decodiertabelle den restlichen individuellen Wertevorrat der ersten Teilfolge des "großen Geräts" aufweist. Abschnitte der individuellen Wertevorräte, insbesondere der ersten Teilfolge, können wiederum in separate Tabellen (Tabellen 7 und 9 für das "große Gerät") aufgeteilt werden, um diese besser räumlich auf einem Chip unterbringen zu können.

**Drittes Ausführungsbeispiel:**

Entsprechend dem Beispiel für zwei Tabellen kann man dieses Verfahren für mehrere Tabellen wiederholen. Hierzu ist lediglich die Konstruktion von entsprechenden Überlapptabellen notwendig, deren Größe (=Anzahl der Einträge) aber lediglich $L_A$-1 ist. Allgemein sind dann auch eine entsprechende Anzahl an nicht notwendig gleichen Konstanten $S_k$ möglich, wobei k=2... (Anzahl der Überlapptabellen + 1).

Das folgende Ausführungsbeispiel gilt für 4 Gerätegrößen, wobei

$L_1$ = 1059,
$L_2$ = 989,
$L_3$ = 615,
$L_4$ = 329.

Die Abtastlänge sei $L_A$ = 18. Es sei außerdem $S_2$=$S_3$=$S_4$=0.

Der serielle Code hierzu ist in Figur 6 dargestellt.

Es werden drei Überlapptabellen (hier als $T_{O2}$, $T_{O3}$ und $T_{O4}$ bezeichnet) benötigt, wobei die Anzahl der Einträge in jeder der Überlapptabellen $L_A$-1=17 ist. Bei einer Abtastlänge $L_A$=18 sind somit folgende Tabellen erforderlich:

Tabelle 10 ($T_{10}$). Tabelle 11 ($T_{O2}$), Tabelle 12 ($T_{O3}$) und Tabelle 13 ($T_{O4}$)

Das in Figur 7 dargestellte Flussdiagramm ist nun auf insgesamt 4 Äste erweitert. Im ASIC muss bei der Montage des Gerätes eingespeichert werden, in welchem der vier möglichen Geräte er sich befindet. Dies erfolgt vorzugsweise durch Vorgabe einer Kennung ID.

In diesem Flussdiagramm ist zusätzlich noch die allgemeine Abfrage

*Wenn* ($POS \in T_1$), *dann*
$POS := POS-S_i$

hinzugefügt, obwohl in diesem Beispiel eigentlich $S_i$=0 für i=2,3,4.

Zu beachten ist wieder, dass es sich bei dem ODER in den Rautensymbolen in diesem Flussdiagramm um ein *exklusives* ODER handelt.

**Viertes Ausführungsbeispiel:**

Hier wird eine weitere Möglichkeit der Ausgestaltung von Tabellen für die vier Codescheiben mit dem Code gemäß Figur 6 erörtert. In der Alternativdarstellung wird die Tabelle $T_{10}$ nun aufgespaltet in 4 neue Tabellen ($T_{N1}$-$T_{N4}$). Diese werden in der Anlage als Tabellen 14 bis 17 bezeichnet.

Die Überlapptabellen $T_{O2}$-$T_{O4}$ sind wieder die Tabellen 11 bis 13 wie beim dritten Ausführungsbeispiel beschrieben. Das Flussdiagramm mit den hier verwendeten 7 Tabellen, also den Tabellen 14 bis 17 ($T_{N1}$-$T_{N4}$) und den Tabellen 11 bis 13 ($T_{O2}$-$T_{O4}$) ist in Figur 8 dargestellt.

In diesem Flussdiagramm ist zusätzlich noch die allgemeine Abfrage

*Wenn* ($POS \in T_{ni}$), *dann*
$POS := POS-S_k$

hinzugefügt, obwohl in diesem Beispiel $S_k$=0 für k=2, 3, 4.

Zu beachten ist wieder, dass es sich bei dem ODER in den Rautensymbolen in diesem Flussdiagramm um ein exclusives ODER handelt.

**Weitere Ausführungsmöglichkeiten und Verallgemeinerungen:**

Es sind weitere Verschachtelungen von Codes denkbar, die hier nur angedeutet werden sollen. Das in Figur 9 dargestellte Diagramm zeigt zum Beispiel schemenhaft einen Code 1, der weitere Teilcodes 2 bis 5 enthält. Entsprechend dem zweiten und vierten Ausführungsbeispiel lässt sich die große Tabelle für Code 1 dann in sieben Tabellen $T_{N1}$-$T_{N7}$ aufspalten.
Hier ist $S_2$=0, aber $S_3$,$S_4$,$S_5 \neq 0$. Zusätzlich zu den Tabellen $TN_1$-$TN_7$ gibt es natürlich noch die entsprechenden Überlapptabellen $T_{O2}$, $T_{O3}$, $T_{O4}$ und $T_{O5}$.

Das Flussdiagram ist für das hier dargestellte Beispiel ist in Figur 10 dargestellt.

Auch hier ist das ODER in den Abfragen (Rautensymbole) wieder ein exklusives ODER.

Ein Flussdiagramm in allgemeinster Form gemäß dem ersten und dritten Ausführungsbeispiel ist in Figur 11 dargestellt.

Ein Flussdiagramm in allgemeinster Form gemäß dem zweiten und vierten Ausführungsbeispiel ist in Figur 12 dargestellt.
Dabei sei der Code 1 mit Tabelle $T_1$ der größte / längste Code, in dem die anderen Codes "enthalten" sind. Benötigt werden ggf. wieder die "Offsets" $S_2$, $S_3$,... der enthaltenen Teilcodes und die entsprechenden Überlapptabellen $T_{O2}$, $T_{O3}$,.... Bei dem zweiten und dritten Ausführungsbeispiel wird die Tabelle $T_1$ in die Tabellen $T_{N1}$, $T_{N2}$,... aufgespaltet.

Anstelle nur ein Codeteil V aus dem ersten Code C1 für den zweiten Code C2 zu übernehmen, kann der Code C2 auch aus mehreren Codeteilen V1, V2 des ersten Codes C1 gebildet werden. Es gilt allgemein:

der zweite Code C2 ist von K gemeinsamen Codeteilen V, V1, V2 gebildet, mit K=natürliche Zahl größer gleich 1, und der dritte Wertevorrat weist eine Anzahl = K x ($L_A$ -1) Codewörter W auf, die bei der Abtastung der zyklisch fortgesetzten Codeteile V, V1, V2 generiert werden, mit $L_A$ = Abtastlänge.

Erläutert anhand eines Beispiels mit zwei Codeteilen V1, V2, also K=2:

Gegeben sei ein Code C1 mit $L_1$=20 und $L_A$=5. Es sei weiterhin $L_2$=13. Die Decodiertabelle für die erste Folge von Codewörtern W ist wieder die Tabelle 2.

Der zweite Code C2 (kleiner Code) ist aus zwei Codeteilen V zusammengesetzt:

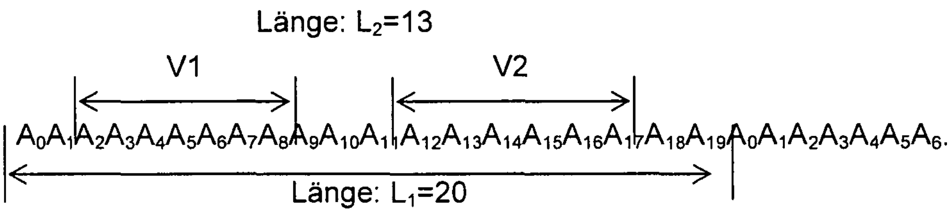


Es gilt:

Anzahl K der benötigten Überlapptabellen = Anzahl K der Codeteile aus dem großen Code. Also hier: zwei nicht zusammenhängende Codeteile V1 und V2 → zwei Überlapptabellen.

Der zur Decodierung des kleinen Codes erforderliche Wertevorrat ist in der Tabelle 18 dargestellt. Die bei beiden Codes C1, C2 gemeinsam genutzten Teile, also die gemeinsam genutzten Teilfolgen, welche die Überlapptabellen bilden, sind durch die geschweiften Klammern identifiziert. Die unterschiedlichen Teile im zweiten Code, also die zweiten Teilfolgen, sind grau markiert. Die Überlapptabellen sind als Tabellen 19 und 20 dargestellt.

Entsprechend muss man bei der Decodierung in den Flussdiagrammen nicht in einer, sondern in K Überlapptabellen nachschauen und auch mit K "offsets" $S_k$ arbeiten.

Es ist bereits angeführt worden, dass der Abtasteinrichtung bzw. dem ASIC bei der Gerätemontage eingespeichert werden muss, welcher Code C1 oder C2 dieser zugeordnet ist. Alternativ könnte die Abtasteinrichtung bei der Inbetriebnahme auch anhand des Überlapp-Bereiches des Codes automatisch erkennen, in welchem Gerät er sich befindet. Hierzu müsste mit dem Gerät in einem Inbetriebnahmemodus eine Umdrehung aufgenommen werden. Nur in einem der in den Flussdiagrammen dargestellten Äste kommt es dann zu keinem Alarm. Dieses könnte der ASIC automatisch erkennen und sich danach automatisch fest auf diesen "Ast" einstellen/programmieren, der keine bzw. am wenigsten Alarme generiert.

Wie bereits erwähnt, ist die Decodiereinrichtung 30 vorteilhaft als ASIC ausgebildet, wobei die Tabellen, also die Speicher für den erforderlichen Wertevorrat jeweils bei der Fertigung des Chips fest verdrahtet ausgebildet sind. Zur schnellen Anpassung des ASIC's an neue Erfordernisse, kann auch eine andere Form von Speichern für die Wertevorräte eingesetzt werden. Besonders vorteilhaft wäre dabei eine Mischform, wobei einerseits ein schneller Zugriff auf die Speicherdaten erreicht werden soll und andererseits auch eine schnelle Anpassung an den Anwendungszweck ermöglicht sein soll. Erreicht wird dies, indem zusätzlich ein noch nach der Maskenherstellung programmierbarer Speicher vorgesehen wird, wobei in diesem programmierbaren Speicher der individuell erforderliche Wertevorrat des Überlapps eingespeichert wird, also der zur Decodierung der zweiten Teilfolge erforderliche dritte Wertevorrat. Der programmierbare Speicher ist ein Festwertspeicher und ist beispielsweise als EPROM ausgebildet. Der Wertevorrat für den hinreichend langen Code C1, der den größten Durchmesser einer benötigten Codescheibe bzw. Trommel abdeckt, ist festverdrahtet ausgeführt und der individuelle Wertevorrat, also die Überlapptabelle, wird in Abhängigkeit des für ein kleineres Gerät verwendeten Ausschnitt V des Codes C1 im EPROM abgelegt, wobei hier nur ($L_A$ - 1) Einträge erforderlich sind. In diesem EPROM kann nun auch die Kennung ID sowie ggf. weitere Kenngrößen, wie beispielsweise die Konstante $S_k$ abgelegt werden.

Die Erfindung ist beim optischen Abtastprinzip besonders vorteilhaft einsetzbar. Dabei ist die Detektoranordnung 10 und die Decodiereinrichtung 30 in vorteilhafter Weise gemeinsam in einem Opto-ASIC untergebracht.

Die Erfindung ist aber nicht auf das optische Abtastprinzip beschränkt, sondern auch bei magnetischen, induktiven sowie kapazitiven Abtastprinzipien einsetzbar.

Tabelle 1:

| Folge der Länge $L_1$ und der Abtastlänge $L_A$<br>$L_1$ : Länge der Folge von Codewörtern<br>$L_A$ : Abtastlänge | | |
|---|---|---|
| Bitpattern (Eingang der Tabelle) | Wort | Position (Ausgang der Tabelle) |
| $A_0A_1A_2...A_{LA-1}$ | $w_0$ | 0 |
| $A_1A_2A_3...A_{LA}$ | $w_1$ | 1 |
| $A_2A_3A_4...A_{LA+1}$ | $w_2$ | 2 |
| ⋮ | ⋮ | ⋮ |
| $A_{L1-2}A_0A_1...A_{LA-3}$ | $w_{L1-2}$ | $L_1$-2 |
| $A_{L1-1}A_0A_1A_2...A_{LA-2}$ | $w_{L1-1}$ | $L_1$-1 |

Tabelle 2:

| Folge der Länge $L_1$ =20 und der Abtastlänge $L_A$ =5<br>$L_1$ : Länge der Folge von Codewörtern<br>$L_A$ : Abtastlänge | | |
|---|---|---|
| Bitpattern | Wort | Position |
| $A_0A_1A_2A_3A_4$ | $w_0$ | 0 |
| $A_1A_2A_3A_4A_5$ | $w_1$ | 1 |
| $A_2A_3A_4A_5A_6$ | $w_2$ | 2 |
| $A_3A_4A_5A_6A_7$ | $w_3$ | 3 |
| $A_4A_5A_6A_7A_8$ | $w_4$ | 4 |
| $A_5A_6A_7A_8A_9$ | $w_5$ | 5 |
| $A_6A_7A_8A_9A_{10}$ | $w_6$ | 6 |
| $A_7A_8A_9A_{10}A_{11}$ | $w_7$ | 7 |
| $A_8A_9A_{10}A_{11}A_{12}$ | $w_8$ | 8 |
| $A_9A_{10}A_{11}A_{12}A_{13}$ | $w_9$ | 9 |
| $A_0A_{11}A_{12}A_{13}A_{14}$ | $w_{10}$ | 10 |
| $A_{11}A_{12}A1_3A_{14}A_{15}$ | $w_{11}$ | 11 |
| $A_{12}A_{13}A_{14}A_{15}A_{16}$ | $w_{12}$ | 12 |
| $A_{13}A_{14}A_{15}A_{16}A_{17}$ | $w_{13}$ | 13 |
| $A_{14}A_{15}A_{16}A_{17}A_{18}$ | $w_{14}$ | 14 |
| $A_{15}A_{16})A_{17}A_{18}A_{19}$ | $w_{15}$ | 15 |
| $A_{16}A_{17}A_{18}A_{19}A_0$ | $w_{16}$ | 16 |
| $A_{17}A_{18}A_{19}A_0A_1$ | $w_{17}$ | 17 |
| $A_{18}A_{19}A_0A_1A_2$ | $w_{18}$ | 18 |
| $A_{19}A_0A_1A_2A_3$ | $w_{19}$ | 19 |

Tabelle 3:

| Folge der Länge $L_2$ und der Abtastlänge $L_A$<br>$L_2$ : Länge der Folge von Codewörtern<br>$L_A$ : Abtastlänge | | |
|---|---|---|
| Bitpattern | Wort | Position |
| $A_{S2}A_{S2+1}A_{S2+2}.A_{S2+LA-1}$ | $w_0$ | 0 |
| $A_{S2+1}A_{S2+2}A_{S2+3}...A_{S2+LA}$ | $w_1$ | 1 |
| $A_{S2+2}A_{S2+3}A_{S2+}4...A_{S2+LA+1}$ | $w_2$ | 2 |
| ⋮ | ⋮ | ⋮ |
| $A_{S2+L2-2}A_{S2+L2-1}A_{S2}A_{S2+1}...A_{S2+LA-3}$ | $w_{L2-2}$ | $L_2$-2 |
| $A_{S2+L2-2}A_{S2+1}A_{S2+1}...A_{S2+LA-2}$ | $w_{L2-1}$ | $L_2$-1 |

Tabelle 4:

| Folge der Länge $L_2$ =11 und der Abtastlänge $L_A$ =5<br>$L_2$ : Länge der Folge von Codewörtern<br>$L_A$ : Abtastlänge | | |
|---|---|---|
| Bitpattern | Wort | Position |
| $A_3A_4A_5A_6A_7$ | $w_0$ | 0 |
| $A_4A_5A_6A_7A_8$ | $w_1$ | 1 |
| $A_5A_6A_7A_8A_9$ | $w_2$ | 2 |
| $A_6A_7A_8A_9A_{10}$ | $w_3$ | 3 |
| $A_7A_8A_9A_{10}A_{11}$ | $w_4$ | 4 |
| $A_8A_9A_{10}A_{11}A_{12}$ | $w_5$ | 5 |
| $A_9A_{10}A_{11}A_{12}A_{13}$ | $w_6$ | 6 |
| $A_{10}A_{11}A_{12}A_{13}A_3$ | $w_7$ | 7 |
| $A_{11}A_{12}A_{13}A_3A_4$ | $w_8$ | 8 |
| $A_{12}A_{13}A_3A_4A_5$ | $w_9$ | 9 |
| $A_{13}A_3A_4A_5A_6$ | $w_{10}$ | 10 |

Gegenüberstellung der Tabelle 2 der ersten Winkelmesseinrichtung und des übereinstimmenden Teils der Tabelle 4 der zweiten Winkelmesseinrichtung mit $S_2$ = Verschiebung der Tabelle 4 gegenüber der Tabelle 2

| | |
|---|---|
| $A_0A_1A_2A_3A_4$ | 0 |
| $A_1A_2A_3A_4A_5$ | 1 |
| $A_2A_3A_4A_5A_6$ | 2 |
| $A_3A_4A_5A_6A_7$ | 3 |
| $A_4A_5A_6A_7A_8$ | 4 |
| $A_5A_6A_7A_8A_9$ | 5 |
| $A_6A_7A_8A_9A_{10}$ | 6 |

(fortgesetzt)

| | |
|---|---|
| $A_7A_8A_9A_{10}A_{11}$ | 7 |
| $A_8A_9A_{10}A_{11}A_{12}$ | 8 |
| $A_9A_{10}A_{11}A_{12}A_{13}$ | 9 |
| $A_{10}A_{11}A_{12}A_{13}A_{14}$ | 10 |
| $A_{11}A_{12}A_{13}A_{14}A_{15}$ | 11 |
| $A_{12}A_{13}A_{14}A_{15}A_{16}$ | 12 |
| $A_{13}A_{14}A_{15}A_{16}A_{17}$ | 13 |
| $A_{14}A_{15}A_{16}A_{17}A_{18}$ | 14 |
| $A_{15}A_{16}A_{17}A_{18}A_{19}$ | 15 |
| $A_{16}A_{17}A_{18}A_{19}A_0$ | 16 |
| $A_{17}A_{18}A_{19}A_0A_1$ | 17 |
| $A_{18}A_{19}A_0A_1A_2$ | 18 |
| $A_{19}A_0A_1A_2A_3$ | 19 |

| | $S_2$=+3 |
|---|---|
| $A_3A_4A_5A_6A_7$ | 0 |
| $A_4A_5A_6A_7A_8$ | 1 |
| $A_5A_6A_7A_8A_9$ | 2 |
| $A_6A_7A_8A_9A_{10}$ | 3 |
| $A_7A_8A_9A_{10}A_{11}$ | 4 |
| $A_8A_9A_{10}A_{11}A_{12}$ | 5 |
| $A_9A_{10}A_{11}A_{12}A_{13}$ | 6 |

Tabelle 5:

| Überlapptabelle der Folge der Länge $L_2$ =11 und der Abtastlänge $L_A$ =5<br>$L_2$ : Länge der Folge von Codewörtern<br>$L_A$ : Abtastlänge | | |
|---|---|---|
| Bitpattern | Wort | Position |
| $A_{10}A_{11}A_{12}A_{13}A_3$ | $w_7$ | 7 |
| $A_{11}A_{12}A_{13}A_3A_4$ | $w_8$ | 8 |
| $A_{12}A_{13}A_3A_4A_5$ | $w_9$ | 9 |
| $A_{13}A_3A_4A_5A_6$ | $w_{10}$ | 10 |

Tabelle 6:

| Überlapptabelle allgemein mit<br>$L_2$ : Länge der Folge von Codewörtern<br>$L_A$ : Abtastlänge<br>$S_2$ : Verschiebung gegenüber der Tabelle 1 | | |
|---|---|---|
| Bitpattern | Wort | Position |
| $A_{S2+L2-LA+1}A_{S2+L2-LA+2}\dots A_{S2+L2-1}A_{S2}$ | $w_{L2-LA+1}$ | $L_2-_{LA}+1$ |
| $A_{S2+L2-LA+2}A_{S2+L2-LA+3}\dots A_{S2}A_{S2+1}$ | $w_{L2-LA+2}$ | $L_2-L_A+2$ |
| ⋮ | ⋮ | ⋮ |
| $A_{S2+L2-2}A_{S2+L2-1}A_{S2}A_{S2+1}\dots A_{S2+LA-1}$ | $w_{L2-2}$ | $L_2-2$ |
| $A_{S2+L2-1}A_{S2}A_{S2+1}A_{S2+2}\dots A_{S2+LA-2}$ | $w_{L2-1}$ | $L_2-1$ |

Tabelle 7:

| Bitpattern | Wort | Position |
|---|---|---|
| $A_0A_1A_2A_3A_4$ | $w_0$ | 0 |
| $A_1A_2A_3A_4A_5$ | $w_1$ | 1 |
| $A_2A_3A_4A_5A_6$ | $w_2$ | 2 |

Tabelle 8:

| Bitpattern | Wort | Position |
|---|---|---|
| $A_3A_4A_5A_6A_7$ | $w_3$ | 3 |
| $A_4A_5A_6A_7A_8$ | $w_4$ | 4 |
| $A_5A_6A_7A_8A_9$ | $w_5$ | 5 |
| $A_6A_7A_8A_9A_{10}$ | $w_6$ | 6 |
| $A_7A_8A_9A_{10}A_{11}$ | $w_7$ | 7 |
| $A_8A_9A_{10}A_{11}A_{12}$ | $w_8$ | 8 |
| $A_9A_{10}A_{11}A_{12}A_{13}$ | $w_9$ | 9 |

Tabelle 9:

| Bitpattern | Wort | Position |
|---|---|---|
| $A_{10}A_{11}A_{12}A_{13}A_{14}$ | $w_{10}$ | 10 |
| $A_{11}A_{12}A_{14}A_{15}$ | $w_{11}$ | 11 |
| $A_{12}A_{13}A_{14}A_{15}A_{16}$ | $w_{12}$ | 12 |
| $A_{13}A_{14}A_{15}A_{16}A_{17}$ | $w_{13}$ | 13 |
| $A_{14}A_{15}A_{16}A_{17}A_{18}$ | $w_{14}$ | 14 |
| $A_{15}A_{16}A_{17}A_{18}A_{19}$ | $w_{15}$ | 15 |
| $A_{16}A_{17}A_{18}A_{19}A_0$ | $w_{16}$ | 16 |
| $A_{17}A_{18}A_{19}A_0A_1$ | $w_{17}$ | 17 |

(fortgesetzt)

| Bitpattern | Wort | Position |
|---|---|---|
| $A_{18}A_{19}A_0A_1A_2$ | $w_{18}$ | 18 |
| $A_{19}A_0A_1A_2A_3$ | $w_{19}$ | 19 |

Tabelle 10:

| für Positionen 0...1058 | | |
|---|---|---|
| Bitpattern | Wort | Position |
| 001101110100111001 | $w_0$ | 0 |
| 011011101001110011 | $w_1$ | 1 |
| 110111010011100110 | $w_2$ | 2 |
| ⋮ | ⋮ | ⋮ |
| 101001101110100111 | $w_{1056}$ | 1056 |
| 010011011101001110 | $w_{1057}$ | 1057 |
| 100110111010011100 | $w_{1058}$ | 1058 |

Tabelle 11:

| Überlapptabelle für Positionen 972...988 | | |
|---|---|---|
| Bitpattern | Wort | Position |
| 001001100010011000 | $w_{972}$ | 972 |
| 010011000100110000 | $w_{973}$ | 973 |
| 100110001001100001 | $w_{974}$ | 974 |
| ⋮ | ⋮ | ⋮ |
| 100001101110100111 | $w_{986}$ | 986 |
| 000011011101001110 | $w_{987}$ | 987 |
| 000110111010011100 | $w_{988}$ | 988 |

Tabelle 12:

| Überlapptabelle für Positionen 598...614 | | |
|---|---|---|
| Bitpattern | Wort | Position |
| 000000111111011110 | $w_{598}$ | 598 |
| 000001111110111100 | $w_{599}$ | 599 |
| 000011111101111001 | $w_{600}$ | 600 |
| ⋮ | ⋮ | ⋮ |
| 111001101110100111 | $w_{612}$ | 612 |
| 110011011101001110 | $w_{613}$ | 613 |
| 100110111010011100 | $w_{614}$ | 614 |

Tabelle 13:

| Überlapptabelle für Positionen 312...328 | | |
|---|---|---|
| Bitpattern | Wort | Position |
| 001110000000100000 | $w_{312}$ | 312 |
| 011100000001000000 | $w_{313}$ | 313 |
| 111000000010000001 | $w_{314}$ | 314 |
| ⋮ | ⋮ | ⋮ |
| 000001101110100111 | $w_{326}$ | 326 |
| 000011011101001110 | $w_{327}$ | 327 |
| 000110111010011100 | $w_{328}$ | 328 |

Tabelle 14:

| Bitpattern | Wort | Position |
|---|---|---|
| 001101110100111001 | $w_0$ | 0 |
| 011011101001110011 | $w_1$ | 1 |
| 110111010011100110 | $w_2$ | 2 |
| . . | . . | . . |
| 000001110000000100 | $w_{309}$ | 309 |
| 000011100000001000 | $w_{310}$ | 310 |
| 000111000000010000 | $w_{311}$ | 311 |

Tabelle 15:

| Bitpattern | Wort | Position |
|---|---|---|
| 001110000000100001 | $w_{312}$ | 312 |
| 011100000001000010 | $w_{313}$ | 313 |
| 111000000010000100 | $w_{314}$ | 314 |
| . . | . . | . . |
| 101000000111111011 | $w_{595}$ | 595 |
| 010000001111110111 | $w_{596}$ | 596 |
| 100000011111101111 | $w_{597}$ | 597 |

Tabelle 16:

| Bitpattern | Wort | Position |
|---|---|---|
| 000000111111011111 | $w_{598}$ | 598 |
| 000001111110111111 | $w_{599}$ | 599 |
| 000011111101111110 | $w_{600}$ | 600 |
| . | . | . |

(fortgesetzt)

| Bitpattern | Wort | Position |
|---|---|---|
| . | . | . |
| 101001001100010011 | $w_{969}$ | 969 |
| 010010011000100110 | $w_{970}$ | 970 |
| 100100110001001100 | $w_{971}$ | 971 |

Tabelle 17:

| Bitpattern | Wort | Position |
|---|---|---|
| 001001100010011000 | $w_{972}$ | 972 |
| 010011000100110000 | $w_{973}$ | 973 |
| 100110001001100001 | $w_{974}$ | 974 |
| . . | . . | . . |
| 101001101110100111 | $w_{1056}$ | 1056 |
| 010011011101001110 | $w_{1057}$ | 1057 |
| 100110111010011100 | $w_{1058}$ | 1058 |

Generierung der Tabelle 18 mit $L_2$ = 13 aus der Tabelle 1 mit $L_1$ = 20:

$L_A$ = 5
$L_1$ : Länge der Folge von Codewörtern
$L_A$ : Abtastlänge

| Bitpattern | Wort | Position |
|---|---|---|
| $A_0A_1A_2A_3A_4$ | $w_0$ | 0 |
| $A_1A_2A_3A_4A_5$ | $w_1$ | 1 |
| $A_2A_3A_4A_5A_6$ | $w_2$ | 2 |
| $A_3A_4A_5A_6A_7$ | $w_3$ | 3 |
| $A_4A_5A_6A_7A_8$ | $w_4$ | 4 |
| $A_5A_6A_7A_8A_9$ | $w_5$ | 5 |
| $A_6A_7A_8A_9A_{10}$ | $w_6$ | 6 |
| $A_7A_8A_9A_{10}A_{11}$ | $w_7$ | 7 |
| $A_8A_9A_{10}A_{11}A_{12}$ | $w_8$ | 8 |
| $A_9A_{10}A_{11}A_{12}A_{13}$ | $w_9$ | 9 |
| $A_{10}A_{11}A_{12}A_{13}A_{14}$ | $w_{10}$ | 10 |
| $A_{11}A_{12}A_{13}A_{14}A_{15}$ | $w_{11}$ | 11 |
| $A_{12}A_{13}A_{14}A_{15}A_{16}$ | $w_{12}$ | 12 |
| $A_{13}A_{14}A_{15}A_{16}A_{17}$ | $w_{13}$ | 13 |
| $A_{14}A_{15}A_{16}A_{17}A_{18}$ | $w_{14}$ | 14 |
| $A_{15}A_{16}A_{17}A_{18}A_{19}$ | $w_{15}$ | 15 |
| $A_{16}A_{17}A_{18}A_{19}A_0$ | $w_{16}$ | 16 |
| $A_{17}A_{18}A_{19}A_0A_1$ | $w_{17}$ | 17 |
| $A_{18}A_{19}A_0A_1A_2$ | $w_{18}$ | 18 |
| $A_{19}A_0A_1A_2A_3$ | $w_{19}$ | 19 |

| Bitpattern | Wort | Position |
|---|---|---|
| $A_2A_3A_4A_5A_6$ | $w_0$ | 0 |
| $A_3A_4A_5A_6A_7$ | $w_1$ | 1 |
| $A_4A_5A_6A_7A_8$ | $w_2$ | 2 |
| $A_5A_6A_7A_8A_{12}$ | $w_3$ | 3 |
| $A_6A_7A_8A_{12}A_{13}$ | $w_4$ | 4 |
| $A_7A_8A_{12}A_{13}A_{14}$ | $w_5$ | 5 |
| $A_8A_{12}A_{13}A_{14}A_{15}$ | $w_6$ | 6 |
| $A_{12}A_{13}A_{14}A_{15}A_{16}$ | $w_7$ | 7 |
| $A_{13}A_{14}A_{15}A_{16}A_{17}$ | $w_8$ | 8 |
| $A_{14}A_{15}A_{16}A_{17}A_2$ | $w_9$ | 9 |
| $A_{15}A_{16}A_{17}A_2A_3$ | $w_{10}$ | 10 |
| $A_{16}A_{17}A_2A_3A_4$ | $w_{11}$ | 11 |
| $A_{17}A_2A_3A_4A_5$ | $w_{12}$ | 12 |

Tabelle 19:

| Bitpattern | Wort | Position |
|---|---|---|
| $A_5A_6A_7A_8A_{12}$ | $w_3$ | 3 |
| $A_6A_7A_8A_{12}A_{13}$ | $w_4$ | 4 |
| $A_7A_8A_{12}A_{13}A_{14}$ | $w_5$ | 5 |
| $A_8A_{12}A_{13}A_{14}A_{15}$ | $w_6$ | 6 |

Tabelle 20:

| Bitpattern | Wort | Position |
|---|---|---|
| $A_{14}A_{15}A_{16}A_{17}A_2$ | $w_9$ | 9 |
| $A_{15}A_{16}A_{17}A_2A_3$ | $w_{10}$ | 10 |
| $A_{16}A_{17}A_2A_3A_4$ | $w_{11}$ | 11 |
| $A_{17}A_2A_3A_4A_5$ | $w_{12}$ | 12 |

Tabelle 21

| Länge des Codes C1 = 20:<br>Abtastlänge = 7<br>Bitfolge: 10101100110000110110 | |
|---|---|
| **Bitpattern** | **Position** |
| 1010110 | 0 |
| 0101100 | 1 |
| 1011001 | 2 |
| 0110011 | 3 |
| 1100110 | 4 |
| 1001100 | 5 |
| 0011000 | 6 |
| 0110000 | 7 |
| 1100001 | 8 |
| 1000011 | 9 |
| 0000110 | 10 |
| 0001101 | 11 |
| 0011011 | 12 |
| 0110110 | 13 |
| 1101101 | 14 |
| 1011010 | 15 |
| 0110101 | 16 |
| 1101010 | 17 |
| 1010101 | 18 |

(fortgesetzt)

| Bitpattern | Position |
|---|---|
| 0101011 | 19 |

Tabelle 22

Länge des Codes C2 = 11:
Abtastlänge = 7
Bitfolge: 10101100110 (es werden die ersten 11 Bits des Codes C1 genommen)

| Bitpattern | Position |
|---|---|
| 1010110 | 0 |
| 0101100 | 1 |
| 1011001 | 2 |
| 0110011 | 3 |
| 1100110 | 4 |
| 1001101 | 5 |
| 0011010 | 6 |
| 0110101 | 7 |
| 1101010 | 8 |
| 1010101 | 9 |
| 0101011 | 10 |

**Patentansprüche**

1. Winkelmesseinrichtung mit einer Abtasteinrichtung (20), die dazu ausgelegt ist, die Abtastung zumindest eines geschlossenen seriellen ersten Codes (C1) sowie die Abtastung zumindest eines geschlossenen seriellen zweiten Codes (C2) zu ermöglichen,
wobei die Länge des zweiten Codes (C2) geringer ist als die Länge des ersten Codes (C1) und der erste Code (C1) und der zweite Code (C2) zumindest einen gemeinsamen Codeteil (V) aufweisen, mit:

   einer Detektoranordnung (10), die zur Generierung einer ersten Folge von Codewörtern (W) einer vorgegebenen Abtastlänge ($L_A$), bei der Abtastung des geschlossenen ersten Codes (C1) ausgelegt ist,
   wobei die erste Folge aus einer ersten Teilfolge und einer gemeinsamen Teilfolge besteht, wobei die gemeinsame Teilfolge bei Abtastung des gemeinsamen Codeteils (V) entsteht, und zur Generierung einer zweiten Folge von Codewörtern (W) der vorgegebenen Abtastlänge ($L_A$), bei der Abtastung des geschlossenen zweiten Codes (C2), wobei die zweite Folge aus einer zweiten Teilfolge und der gemeinsamen Teilfolge besteht, und die gemeinsame Teilfolge bei Abtastung des gemeinsamen Codeteils (V) entsteht;
   **gekennzeichnet durch** eine Decodiereinrichtung (30), die dazu ausgelegt ist, die erste Folge und die zweite Folge von Codewörtern (W) zu decodieren, wobei der erste Code (C1) und der zweite Code (C2) sowie die Abtastlänge ($L_A$) derart gewählt sind, dass die Codewörter (W) der ersten Folge sowie die Codewörter (W) der zweiten Folge eine Hamming-Distanz größer 1 aufweisen.

2. Winkelmesseinrichtung nach Anspruch 1, **dadurch gekennzeichnet, dass** die Decodiereinrichtung (30) einen ersten Wertevorrat von aufeinander folgenden Codewörtern (W) aufweist, der jeweils zur Decodierung der Codewörter (W) der gemeinsamen Teilfolge des ersten Codes (C1) und des zweiten Codes (C2) nutzbar ist, und
die Decodiereinrichtung (30) einen zweiten Wertevorrat von Codewörtern (W) aufweist, wobei dieser Wertevorrat zur Decodierung der ersten Teilfolge von Codewörtern (W) nutzbar ist, und
die Decodiereinrichtung (30) einen dritten Wertevorrat von Codewörtern (W) aufweist, wobei dieser Wertevorrat zur Decodierung der zweiten Teilfolge von Codewörtern (W) nutzbar ist.

**3.** Winkelmesseinrichtung nach Anspruch 2, **dadurch gekennzeichnet, dass** der zweite Code (C2) von K gemeinsamen Codeteilen (V) gebildet ist, mit K=natürliche Zahl größer gleich 1, und dass der dritte Wertevorrat eine Anzahl = K x ($L_A$ -1) Codewörter (W) aufweist, die bei der Abtastung der zyklisch fortgesetzten Codeteile (V) generiert werden, mit $L_A$ = Abtastlänge.

**4.** Winkelmesseinrichtung nach Anspruch 3, **dadurch gekennzeichnet, dass** K=1, und der zweite serielle Code (C2) vollständig von dem gemeinsamen Codeteil (V) gebildet ist.

**5.** Winkelmesseinrichtung nach einem der vorhergehenden Ansprüche 2 bis 4, **dadurch gekennzeichnet, dass** die ersten, zweiten und dritten Wertevorräte fest verdrahtet in einem ASIC vorliegen.

**6.** Winkelmesseinrichtung nach einem der Ansprüche 2 bis 4, **dadurch gekennzeichnet, dass** der dritte Wertevorrat in einem programmierbaren Festwertspeicher abgespeichert ist und der erste Wertevorrat sowie der zweite Wertevorrat fest verdrahtet vorliegen.

**7.** Winkelmesseinrichtung nach einem der vorhergehenden Ansprüche 2 bis 6, **dadurch gekennzeichnet, dass** zur Decodierung der ersten Folge der erste und der zweite Wertevorrat auswählbar ist, und dass zur Decodierung der zweiten Folge der erste Wertevorrat und der dritte Wertevorrat auswählbar ist.

**8.** Winkelmesseinrichtung nach einem der vorhergehenden Ansprüche 2 bis 7, **dadurch gekennzeichnet, dass** die Decodiereinrichtung (30) in Abhängigkeit einer Kennung (ID), welche die zu dekodierenden Folgen von Codewörtern (W) voneinander unterscheidbar definiert, in einer ersten oder in einer zweiten Betriebsweise betreibbar ist, wobei in der ersten Betriebsweise die erste Folge von Codewörtern (W) durch den ersten Wertevorrat und den zweiten Wertevorrat decodierbar ist und in der zweiten Betriebsweise die zweite Folge von Codewörtern (W) durch den ersten Wertevorrat und den dritten Wertevorrat decodierbar ist.

**9.** Baureihe von Winkelmesseinrichtungen, umfassend zumindest eine erste Winkelmesseinrichtung und eine zweite Winkelmesseinrichtung, wobei die erste Winkelmesseinrichtung einen ersten Codeträger mit einem geschlossenen seriellen ersten Code (C1) und eine den ersten Codeträger abtastende Abtasteinrichtung (20) aufweist;
die zweite Winkelmesseinrichtung einen zweiten Codeträger mit einem geschlossenen seriellen zweiten Code (C2) und eine den zweiten Codeträger abtastende Abtasteinrichtung (20) aufweist, wobei
die Länge des zweiten Codes (C2) geringer ist als die Länge des ersten Codes (C1) und der erste Code (C1) und der zweite Code (C2) zumindest einen gemeinsamen Codeteil (V) aufweisen, und die Abtasteinrichtungen (20) der Winkelmesseinrichtungen der Baureihe identisch sind, und jeweils eine Detektoranordnung (10) aufweisen, die zur Generierung einer ersten Folge von Codewörtern (W) einer vorgegebenen Abtastlänge ($L_A$), bei der Abtastung des geschlossenen ersten Codes (C1) ausgelegt ist,
wobei die erste Folge aus einer ersten Teilfolge und einer gemeinsamen Teilfolge besteht, wobei die gemeinsame Teilfolge bei Abtastung des gemeinsamen Codeteils (V) entsteht, und zur Generierung einer zweiten Folge von Codewörtern (W) der vorgegebenen Abtastlänge ($L_A$), bei der Abtastung des geschlossenen zweiten Codes (C2) ausgelegt ist,
wobei die zweite Folge aus einer zweiten Teilfolge und der gemeinsamen Teilfolge besteht, wobei die gemeinsame Teilfolge bei Abtastung des gemeinsamen Codeteils (V) entsteht, **dadurch gekennzeichnet, dass** die Abtasteinrichtungen (20) jeweils eine Decodiereinrichtung (30) aufweisen, die dazu ausgelegt ist, die erste Folge und die zweite Folge von Codewörtern (W) zu decodieren, wobei der erste Code (C1) und der zweite Code (C2) sowie die Abtastlänge ($L_A$) derart gewählt sind, dass die Codewörter (W) der ersten Folge sowie die Codewörter (W) der zweiten Folge eine Hamming-Distanz größer 1 aufweisen.

**10.** Baureihe von Winkelmesseinrichtungen nach Anspruch 9, **dadurch gekennzeichnet, dass** die Decodiereinrichtung (30) einen ersten Wertevorrat von aufeinander folgenden Codewörtern (W) aufweist, der jeweils zur Decodierung der Codewörter (W) der gemeinsamen Teilfolge des ersten Codes (C1) und des zweiten Codes (C2) nutzbar ist, und die Decodiereinrichtung (30) einen zweiten Wertevorrat von Codewörtern (W) aufweist, wobei dieser Wertevorrat zur Decodierung der ersten Teilfolge von Codewörtern (W) nutzbar ist, und
die Decodiereinrichtung (30) einen dritten Wertevorrat von Codewörtern (W) aufweist, wobei dieser Wertevorrat zur Decodierung der zweiten Teilfolge von Codewörtern (W) nutzbar ist

**11.** Baureihe von Winkelmesseinrichtungen nach Anspruch 10, **dadurch gekennzeichnet, dass** zur Decodierung der ersten Folge der erste und der zweite Wertevorrat auswählbar ist, und dass zur Decodierung der zweiten Folge der erste Wertevorrat und der dritte Wertevorrat auswählbar ist.

## Claims

1. Angle-measuring device having a scanning device (20) which is designed to make it possible to scan at least one closed serial first code (C1) and to scan at least one closed serial second code (C2), the length of the second code (C2) being shorter than the length of the first code (C1), and the first code (C1) and the second code (C2) having at least one common code part (V), having:

   a detector arrangement (10) which is designed to generate a first sequence of code words (W) of a predefined scanning length ($L_A$) when scanning the closed first code (C1), the first sequence consisting of a first partial sequence and a common partial sequence, the common partial sequence being produced when scanning the common code part (V), and to generate a second sequence of code words (W) of the predefined scanning length ($L_A$) when scanning the closed second code (C2), the second sequence consisting of a second partial sequence and the common partial sequence, and the common partial sequence being produced when scanning the common code part (V); **characterized by** a
   decoding device (30) which is designed to decode the first sequence and the second sequence of code words (W), the first code (C1) and the second code (C2) and the scanning length ($L_A$) being selected in such a manner that the code words (W) in the first sequence and the code words (W) in the second sequence have a Hamming distance of greater than 1.

2. Angle-measuring device according to Claim 1, **characterized in that**
   the decoding device (30) has a first set of values for successive code words (W), which set of values can be respectively used to decode the code words (W) in the common partial sequence of the first code (C1) and of the second code (C2), and
   the decoding device (30) has a second set of values for code words (W), this set of values being able to be used to decode the first partial sequence of code words (W), and
   the decoding device (30) has a third set of values for code words (W), this set of values being able to be used to decode the second partial sequence of code words (W).

3. Angle-measuring device according to Claim 2, **characterized in that** the second code (C2) is formed by K common code parts (V), with K=natural number greater than or equal to 1, and **in that** the third set of values has a number = K x ($L_A$ - 1) of code words (W) which are generated when scanning the cyclically continued code parts (V), with $L_A$ = scanning length.

4. Angle-measuring device according to Claim 3, **characterized in that** K=1 and the second serial code (C2) is completely formed by the common code part (V).

5. Angle-measuring device according to one of the preceding Claims 2 to 4, **characterized in that** the first, second and third sets of values are hardwired in an ASIC.

6. Angle-measuring device according to one of Claims 2 to 4, **characterized in that** the third set of values is stored in a programmable read-only memory and the first set of values and the second set of values are hard-wired.

7. Angle-measuring device according to one of the preceding Claims 2 to 6, **characterized in that** the first and second sets of values can be selected to decode the first sequence, and **in that** the first set of values and the third set of values can be selected to decode the second sequence.

8. Angle-measuring device according to one of the preceding Claims 2 to 7, **characterized in that** the decoding device (30) can be operated in a first operating mode or in a second operating mode on the basis of an identifier (ID) which defines the sequences of code words (W) to be decoded in a manner such that they can be distinguished from one another, the first sequence of code words (W) being able to be decoded by means of the first set of values and the second set of values in the first operating mode, and the second sequence of code words (W) being able to be decoded by means of the first set of values and the third set of values in the second operating mode.

9. Series of angle-measuring devices, comprising at least one first angle-measuring device and one second angle-measuring device,

the first angle-measuring device having a first code carrier with a closed serial first code (C1) and a scanning device (20) which scans the first code carrier;
the second angle-measuring device having a second code carrier with a closed serial second code (C2) and a scanning device (20) which scans the second the length of the second code (C2) being shorter than the length of the first code (C1), and the first code (C1) and the second code (C2) having at least one common code part (V), and the scanning devices (20) of the angle-measuring devices in the series being identical and each having a detector arrangement (10) which is designed to generate a first sequence of code words (W) of a predefined scanning length ($L_A$) when scanning the closed first code (C1), the first sequence consisting of a first partial sequence and a common partial sequence, the common partial sequence being produced when scanning the common code part (V), and to generate a second sequence of code words (w) of the predefined scanning length ($L_A$) when scanning the closed second code (C2), the second sequence consisting of a second partial sequence and the common partial sequence, the common partial sequence being produced when scanning the common code part (V), **characterized in that** the scanning devices (20) each have a decoding device (30) which is designed to decode the first sequence and the second sequence of code words (W), the first code (C1) and the second code (C2) and the scanning length ($L_A$) being selected in such a manner that the code words (W) in the first sequence and the code words (W) in the second sequence have a Hamming distance of greater than 1.

**10.** Series of angle-measuring devices according to Claim 9, **characterized in that** the decoding device (30) has a first set of values for successive code words (W), which set of values can be respectively used to decode the code words (W) in the common partial sequence of the first code (C1) and of the second code (C2), and
the decoding device (30) has a second set of values for code words (W), this set of values being able to be used to decode the first partial sequence of code words (W), and
the decoding device (30) has a third set of values for code words (W), this set of values being able to be used to decode the second partial sequence of code words (W).

**11.** Series of angle-measuring devices according to Claim 10, **characterized in that** the first and second sets of values can be selected to decode the first sequence, and **in that** the first set of values and the third set of values can be selected to decode the second sequence.

**Revendications**

**1.** Dispositif de mesure angulaire avec un dispositif d'analyse (20) qui est conçu pour permettre l'analyse d'au moins un premier code de série fermé (C1) ainsi que l'analyse d'au moins un deuxième code de série fermé (C2), la longueur du deuxième code (C2) étant plus faible que la longueur du premier code (C1) et le premier code (C1) et le deuxième code (C2) comportant au moins une partie de code commune (V), avec :

un agencement de détecteurs (10) qui est conçu pour générer une première suite de mots de code (W) d'une longueur d'analyse prédéfinie ($L_A$), lors de l'analyse du premier code fermé (C1),
la première suite étant composée d'une première partie de suite et d'une partie de suite commune, la partie de suite commune se formant lors de l'analyse de la partie de code commune (V) et pour générer une deuxième suite de mots de code (W) de la longueur d'analyse ($L_A$) prédéfinie, lors de l'analyse du deuxième code fermé (C2), la deuxième suite étant composée d'une deuxième partie de suite et de la partie de suite commune et la partie de suite commune se formant lors de l'analyse de la partie de code commune (V),
**caractérisé par** un dispositif de décodage (30), qui est conçu pour décoder la première suite et la deuxième suite de mots de code (W), le premier code (C1) et le deuxième code (C2) ainsi que la longueur d'analyse ($L_A$) étant choisis de telle manière que les mots de code (W) de la première suite ainsi que les mots de code (W) de la deuxième suite présentent une distance de Hamming supérieure à 1.

**2.** Dispositif de mesure angulaire selon la revendication 1, **caractérisé en ce que** le dispositif de décodage (30) comporte une première réserve de valeurs de mots de code (W) se succédant, qui peut être utilisée respectivement pour décoder les mots de code (W) de la partie de suite commune du premier code (C1) et du deuxième code (C2), et
le dispositif de décodage (30) comporte une deuxième réserve de valeurs de mots de code (W), cette réserve de valeurs pouvant être utilisée pour décoder la première partie de suite de mots de code (W), et
le dispositif de décodage (30) comporte une troisième réserve de valeurs de mots de code (W), cette réserve de valeurs pouvant être utilisée pour décoder la deuxième partie de suite de mots de code (W).

3. Dispositif de mesure angulaire selon la revendication 2, **caractérisé en ce que** le deuxième code (C2) est formé de K parties de code communes (V), avec K = nombre entier naturel supérieur ou égal à 1 et **en ce que** la troisième réserve de valeurs comporte un nombre = K x ($L_A$ -1) mots de code (W), qui sont générés lors de l'analyse des parties de code (V) cycliquement continues avec $L_A$ = longueur d'analyse.

4. Dispositif de mesure angulaire selon la revendication 3, **caractérisé en ce que** K = 1 et le deuxième code de série (C2) est complètement formé par la partie de code commune (V).

5. Dispositif de mesure angulaire selon l'une quelconque des revendications précédentes 2 à 4, **caractérisé en ce que** les première, deuxième et troisième réserves de valeurs existent fixement câblées dans un circuit intégré spécifique à une application.

6. Dispositif de mesure angulaire selon l'une quelconque des revendications 2 à 4, **caractérisé en ce que** la troisième réserve de valeurs est mémorisée dans une mémoire morte programmable et la première réserve de valeurs ainsi que la deuxième réserve de valeurs existent fixement câblées.

7. Dispositif de mesure angulaire selon l'une quelconque des revendications précédentes 2 à 6, **caractérisé en ce que** la première et la deuxième réserve de valeurs peuvent être choisies pour décoder la première suite et **en ce que** la première réserve de valeurs et la troisième réserve de valeurs peuvent être choisies pour décoder la deuxième suite.

8. Dispositif de mesure angulaire selon l'une quelconque des revendications précédentes 2 à 7, **caractérisé en ce que** le dispositif de décodage (30) peut être actionné dans un premier ou un deuxième mode de fonctionnement en fonction d'une identification (ID), qui définit les suites à décoder de mots de code (W) de manière différenciable l'une de l'autre, la première suite de mots de code (W) pouvant être décodée dans le premier mode de fonctionnement par la première réserve de valeurs et la deuxième réserve de valeurs et la deuxième suite de mots de code (W) pouvant être décodée dans le deuxième mode de fonctionnement par la première réserve de valeurs et la troisième réserve de valeurs.

9. Série de dispositifs de mesure angulaire comprenant au moins un premier dispositif de mesure angulaire et un deuxième dispositif de mesure angulaire, le premier dispositif de mesure angulaire comportant un premier support de code avec un premier code de série fermé (C1) et un dispositif d'analyse (20) analysant le premier support de code, le deuxième dispositif de mesure angulaire comportant un deuxième support de code avec un deuxième code de série fermé (C2) et un dispositif d'analyse (20) analysant le deuxième support de code,
la longueur du deuxième code (C2) étant inférieure à la longueur du premier code (C1) et le premier code (C1) et le deuxième code (C2) comportant au moins une partie de code commune (V), et les dispositifs d'analyse (20) des dispositifs de mesure angulaire de la série étant identiques et comportant respectivement un agencement de détecteurs (10), qui est conçu pour générer une première suite de mots de code (W) d'une longueur d'analyse prédéfinie ($L_A$) lors de l'analyse du premier code fermé (C1), la première suite étant composée d'une première partie de suite et d'une partie de suite commune, la partie de suite commune se formant lors de l'analyse de la partie de code commune (V) et étant conçue pour générer une deuxième suite de mots de code (W) de la longueur d'analyse prédéfinie ($L_A$) lors de l'analyse du deuxième code fermé (C2), la deuxième suite étant composée d'une deuxième partie de suite et de la partie de suite commune, la partie de suite commune se formant lors de l'analyse de la partie de code commune (V), **caractérisé en ce que** les dispositifs d'analyse (20) comportent respectivement un dispositif de décodage (30) qui est conçu pour décoder la première suite et la deuxième suite de mots de code (W), le premier code (C1) et le deuxième code (C2) ainsi que la longueur d'analyse ($L_A$) sont choisis de telle manière que les mots de code (W) de la première suite ainsi que les mots de code (W) de la deuxième suite comportent une distance de Hamming supérieure à 1.

10. Série de dispositifs de mesure angulaire selon la revendication 9, **caractérisée en ce que** le dispositif de décodage (30) comporte une première réserve de valeurs de mots de code (W) se succédant, qui peut être respectivement utilisée pour décoder les mots de code (W) de la partie de suite commune du premier code (C1) et du deuxième code (C2), et
le dispositif de décodage (30) comporte une deuxième réserve de valeurs de mots de code (W), cette réserve de valeurs pouvant être utilisée pour décoder la première partie de suite de mots de code (W), et
le dispositif de décodage (30) comporte une troisième réserve de valeurs de mots de code (W), cette réserve de valeurs pouvant être utilisée pour décoder la deuxième partie de suite de mots de code (W).

**11.** Série de dispositifs de mesure angulaire selon la revendication 10, **caractérisée en ce que** la première et la deuxième réserve de valeurs peuvent être choisies pour décoder la première suite et **en ce que** la première réserve de valeurs et la troisième réserve de valeurs peuvent être choisies pour décoder la deuxième suite.

FIG. 1

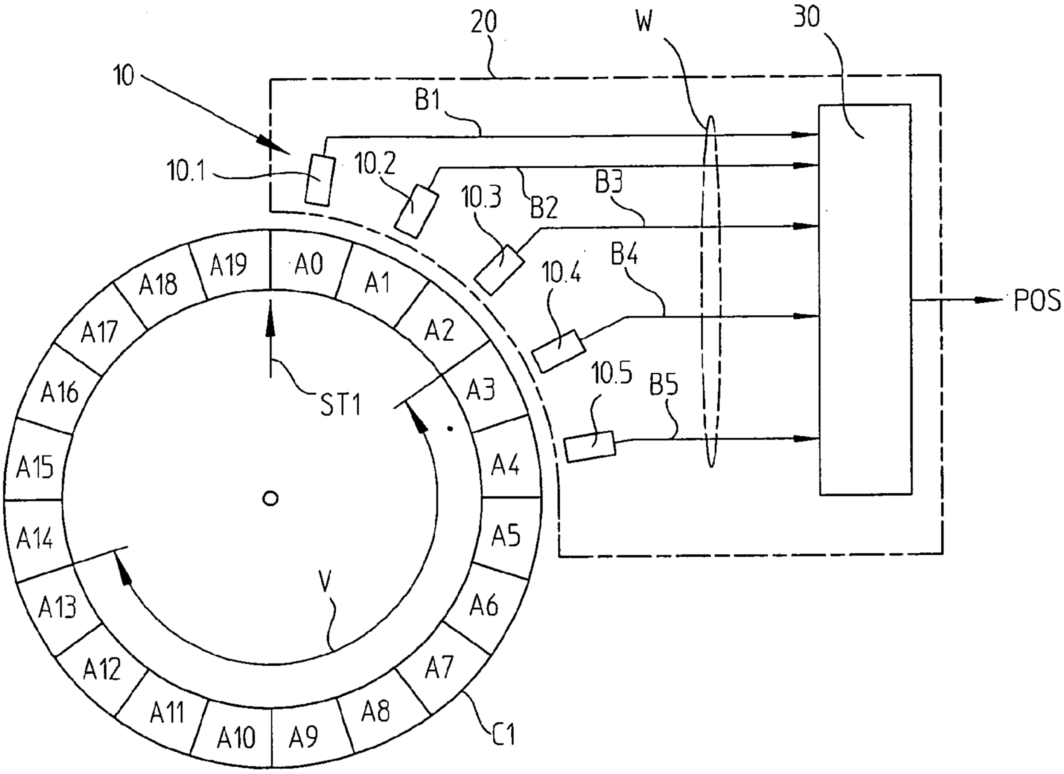
10
20
W
30
B1
10.1
10.2
B2
B3
10.3
10.4
B4
10.5
B5
POS
A0
A1
A2
A3
A4
A5
A6
A7
A8
A9
A10
A11
A12
A13
A14
A15
A16
A17
A18
A19
ST1
V
C1

FIG. 2

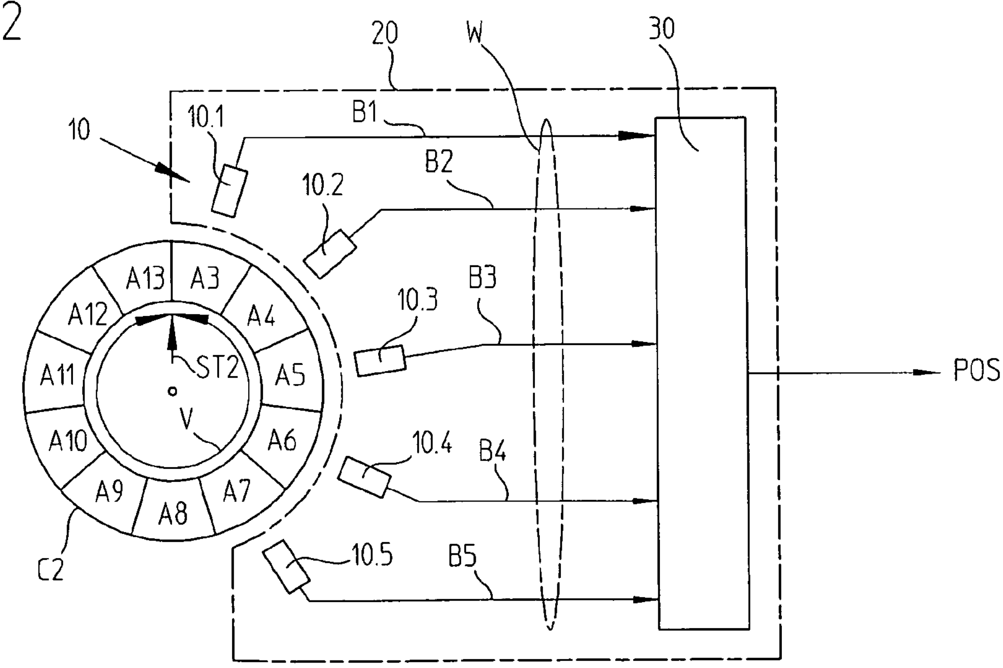
10
20
W
30
10.1
B1
B2
10.2
A13
A3
A4
A5
A6
A7
A8
A9
A10
A11
A12
ST2
V
10.3
B3
10.4
B4
10.5
B5
C2
POS

FIG. 3

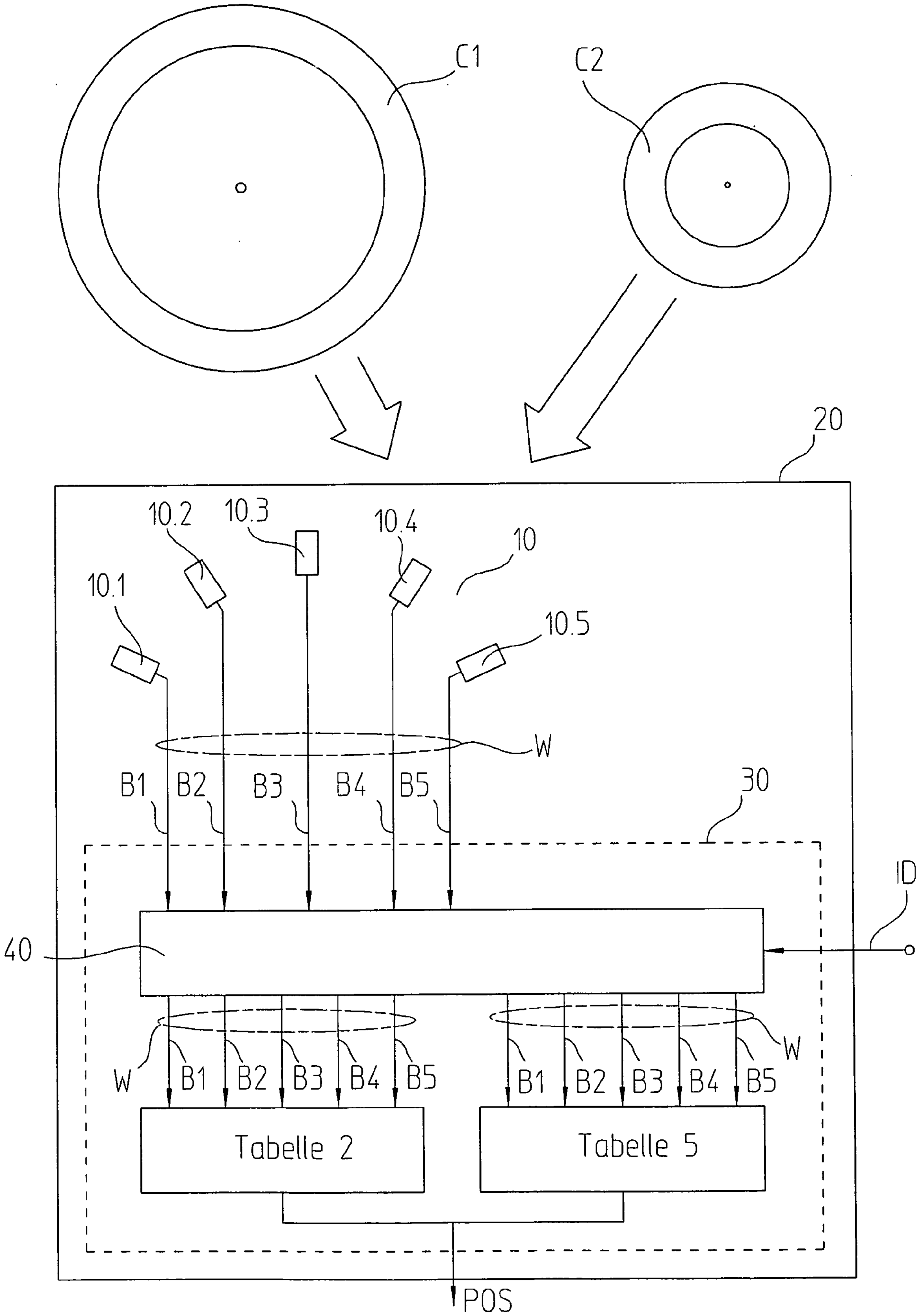
C1
C2
20
10.2
10.3
10.4
10
10.1
10.5
W
B1
B2
B3
B4
B5
30
ID
40
W
B1
B2
B3
B4
B5
B1
B2
B3
B4
B5
W
Tabelle 2
Tabelle 5
POS

FIG. 4

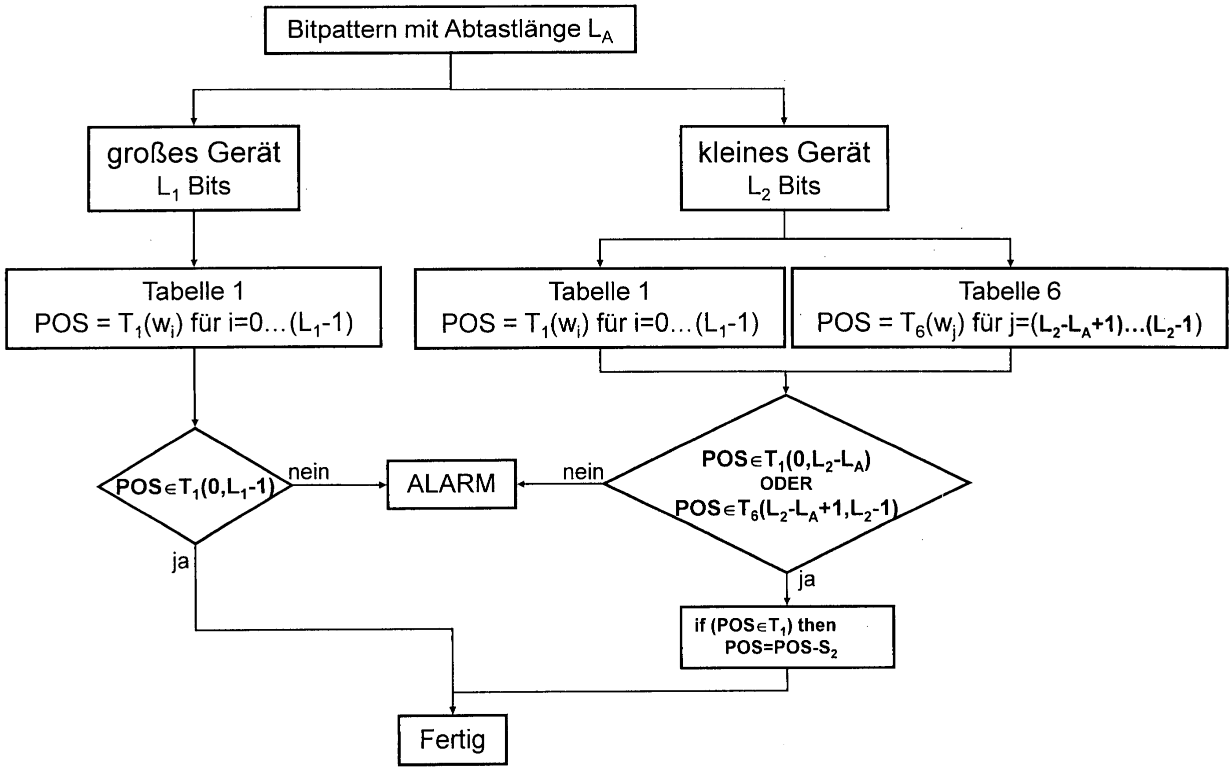
Bitpattern mit Abtastlänge $L_A$
großes Gerät
$L_1$ Bits
kleines Gerät
$L_2$ Bits
Tabelle 1
POS = $T_1(w_i)$ für i=0...($L_1$-1)
Tabelle 1
POS = $T_1(w_i)$ für i=0...($L_1$-1)
Tabelle 6
POS = $T_6(w_j)$ für j=($L_2$-$L_A$+1)...($L_2$-1)
POS∈$T_1$(0,$L_1$-1)
nein
ALARM
nein
POS∈$T_1$(0,$L_2$-$L_A$)
ODER
POS∈$T_6$($L_2$-$L_A$+1,$L_2$-1)
ja
ja
if (POS∈$T_1$) then
POS=POS-$S_2$
Fertig

FIG. 5

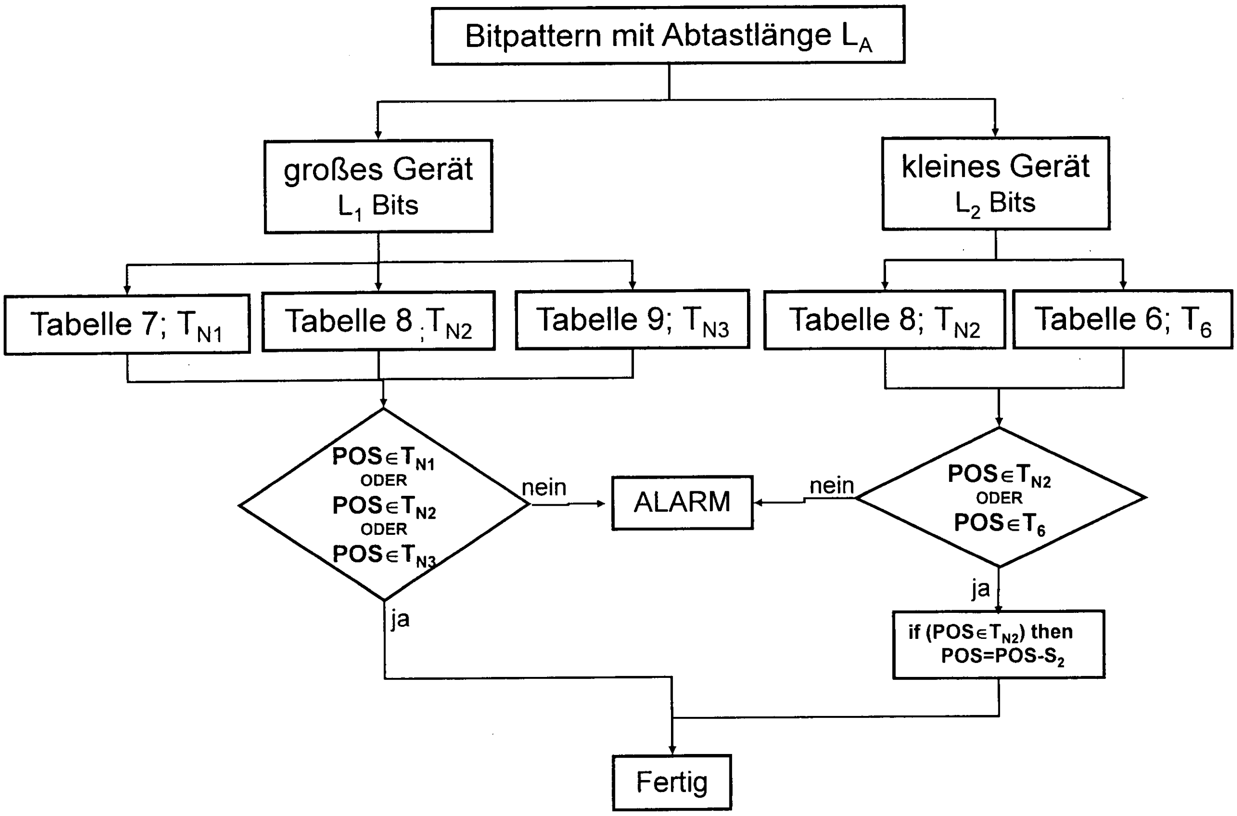

Bitpattern mit Abtastlänge $L_A$
großes Gerät
$L_1$ Bits
kleines Gerät
$L_2$ Bits
Tabelle 7; $T_{N1}$
Tabelle 8; $T_{N2}$
Tabelle 9; $T_{N3}$
Tabelle 8; $T_{N2}$
Tabelle 6; $T_6$
$POS \in T_{N1}$
ODER
$POS \in T_{N2}$
ODER
$POS \in T_{N3}$
nein
ALARM
nein
$POS \in T_{N2}$
ODER
$POS \in T_6$
ja
ja
if ($POS \in T_{N2}$) then
$POS = POS - S_2$
Fertig

FIG. 6

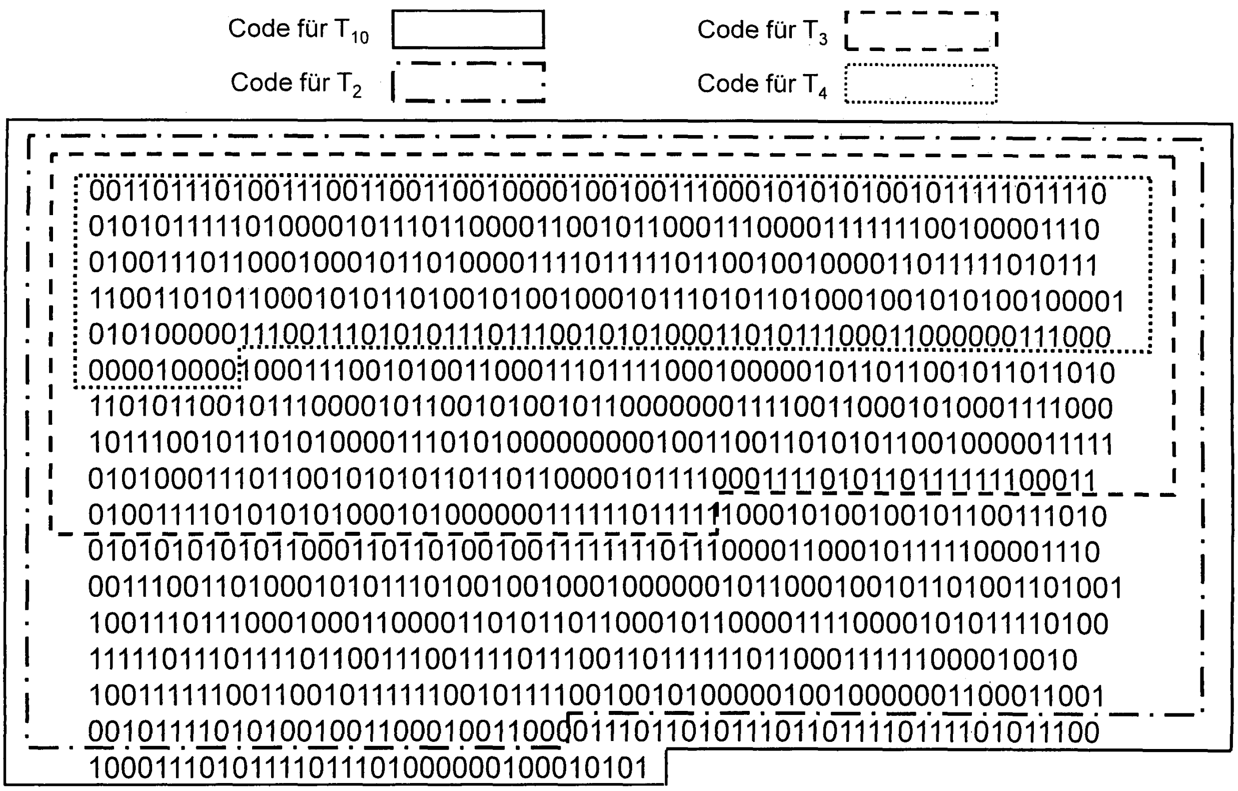
Code für $T_{10}$
Code für $T_3$
Code für $T_2$
Code für $T_4$
0011011101001110011001100100001001001110001010101001011111011110
0101011111010000101110110000110010110001110000111111100100001110
01001110110001000101101000011110111110110010010000110111111010111
1100110101100010101101001010010001011101011010001001010100100001
0101000001110011101010111011100101010001101011100011000000111000
00001000010001110010100110001110111100010000001011011001011011010
1101011001011100001011001010010110000000111100110001010001111000
10111001011010100001110101000000000010011001101010110010000011111
0101000111011001010101101101100001011110001111010110111111100011
0100111101010101000101000000111111011111100010100100101100111010
0101010101011000110110100100111111110111000011000101111100001110
00111001101000101011101001001000100000001011000100101101001101001
1001110111000100011000011010110110001011000011110000101011110100
1111101110111101100111001111011100110111111011000111111000010010
10011111100110010111111001011110010010100000100100000001100011001
0010111101010010011000100110000111011010111011011110111101011100
100011101011110111010000000100010101

FIG. 7

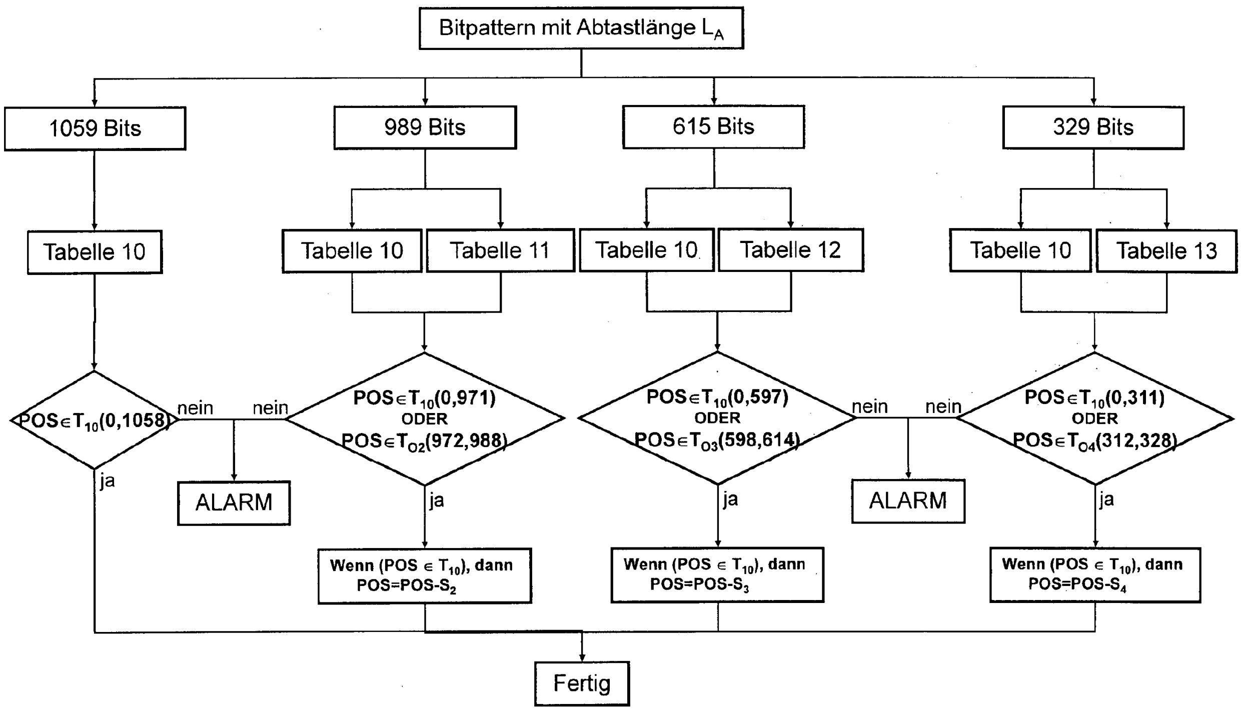
Bitpattern mit Abtastlänge $L_A$
1059 Bits
989 Bits
615 Bits
329 Bits
Tabelle 10
Tabelle 10
Tabelle 11
Tabelle 10
Tabelle 12
Tabelle 10
Tabelle 13
POS∈$T_{10}$(0,1058)
nein
nein
POS∈$T_{10}$(0,971) ODER POS∈$T_{O2}$(972,988)
POS∈$T_{10}$(0,597) ODER POS∈$T_{O3}$(598,614)
nein
nein
POS∈$T_{10}$(0,311) ODER POS∈$T_{O4}$(312,328)
ja
ALARM
ja
ja
ALARM
ja
Wenn (POS ∈ $T_{10}$), dann POS=POS-$S_2$
Wenn (POS ∈ $T_{10}$), dann POS=POS-$S_3$
Wenn (POS ∈ $T_{10}$), dann POS=POS-$S_4$
Fertig

FIG. 8

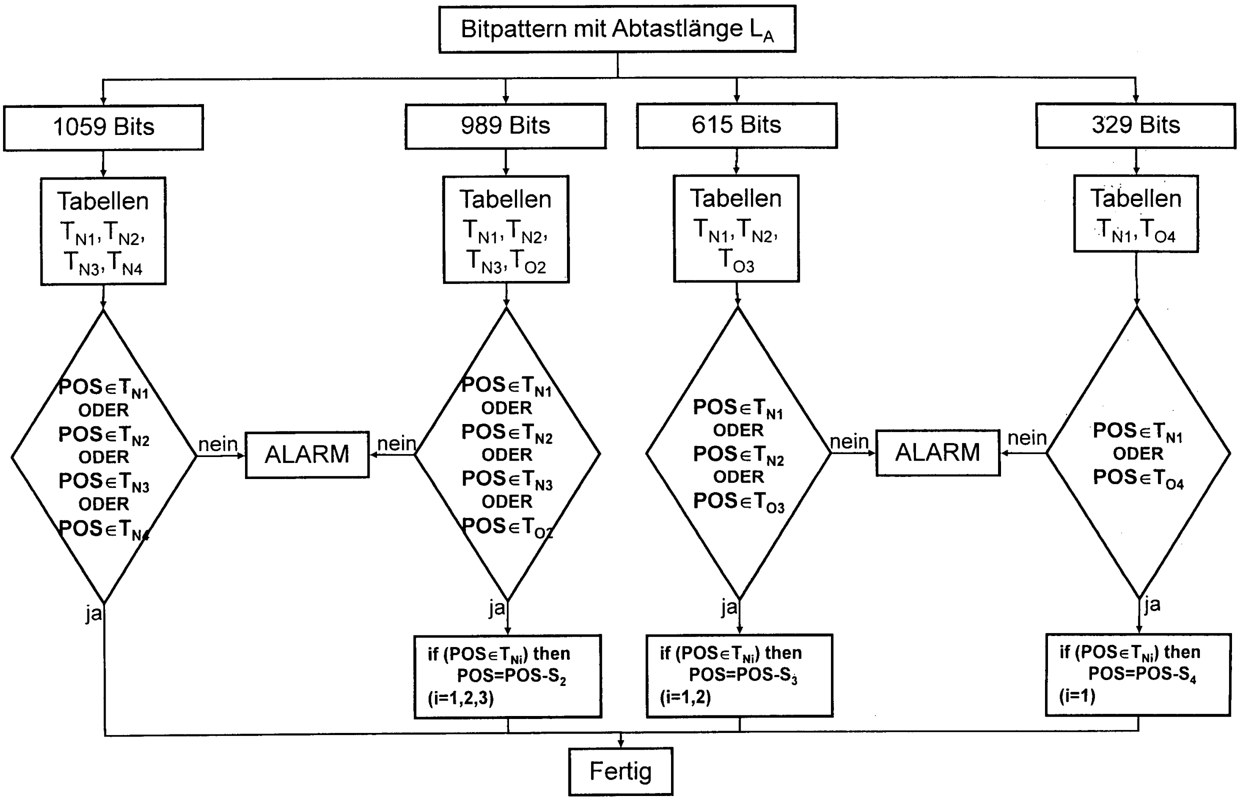
Bitpattern mit Abtastlänge $L_A$
1059 Bits
989 Bits
615 Bits
329 Bits
Tabellen $T_{N1}, T_{N2}, T_{N3}, T_{N4}$
Tabellen $T_{N1}, T_{N2}, T_{N3}, T_{O2}$
Tabellen $T_{N1}, T_{N2}, T_{O3}$
Tabellen $T_{N1}, T_{O4}$
$POS \in T_{N1}$ ODER $POS \in T_{N2}$ ODER $POS \in T_{N3}$ ODER $POS \in T_{N4}$
$POS \in T_{N1}$ ODER $POS \in T_{N2}$ ODER $POS \in T_{N3}$ ODER $POS \in T_{O2}$
$POS \in T_{N1}$ ODER $POS \in T_{N2}$ ODER $POS \in T_{O3}$
$POS \in T_{N1}$ ODER $POS \in T_{O4}$
nein
ALARM
nein
nein
ALARM
nein
ja
ja
ja
ja
if ($POS \in T_{Ni}$) then $POS=POS-S_2$ (i=1,2,3)
if ($POS \in T_{Ni}$) then $POS=POS-S_3$ (i=1,2)
if ($POS \in T_{Ni}$) then $POS=POS-S_4$ (i=1)
Fertig

FIG. 9

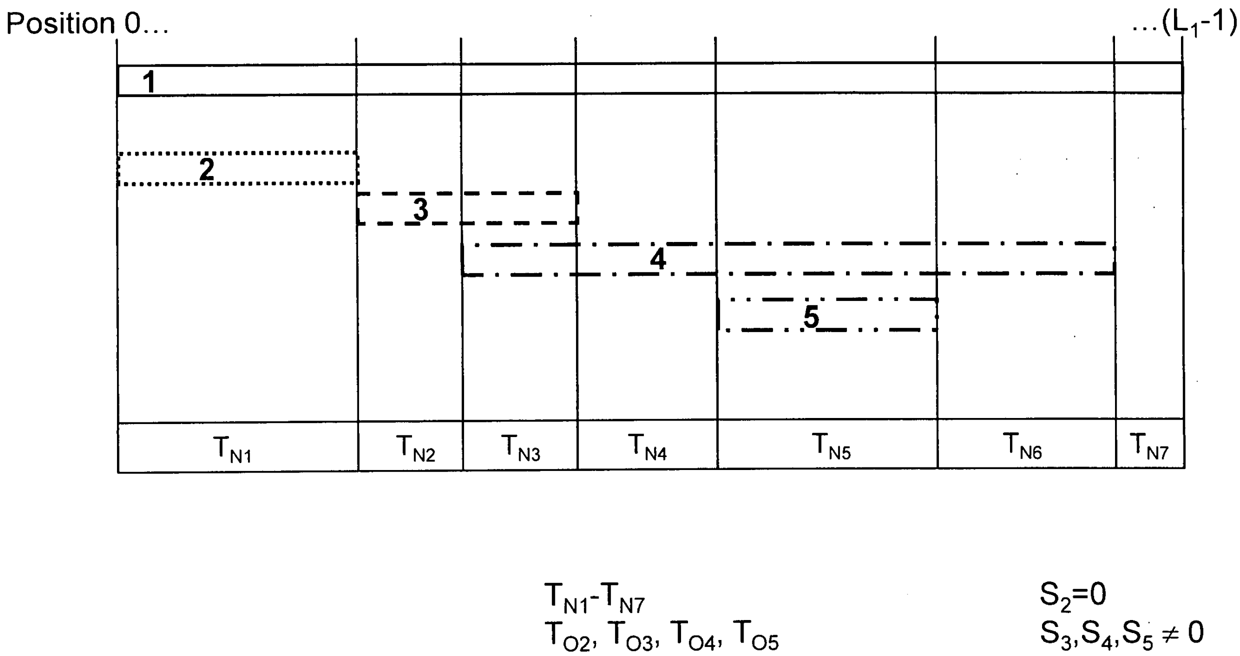
Position 0...
...(L1-1)
1
2
3
4
5
TN1
TN2
TN3
TN4
TN5
TN6
TN7
TN1-TN7
TO2, TO3, TO4, TO5
S2=0
S3,S4,S5 ≠ 0

FIG. 10

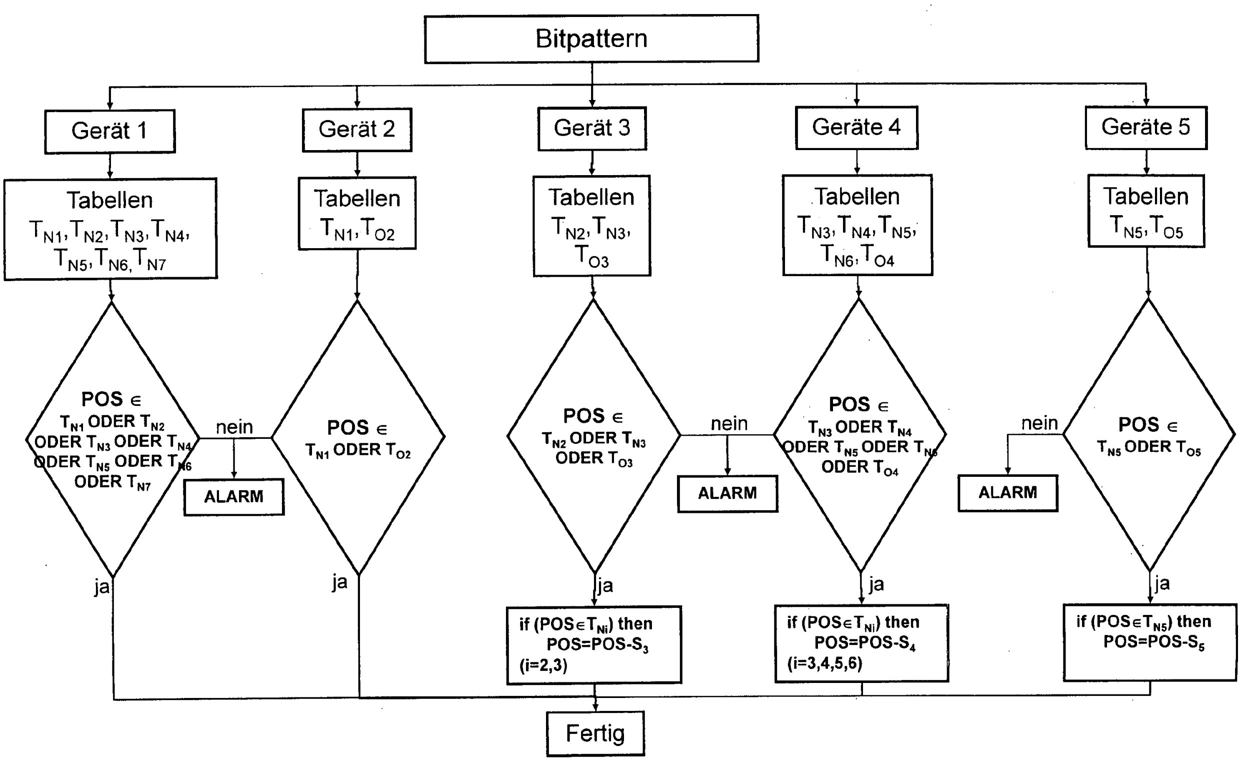
Bitpattern
Gerät 1
Gerät 2
Gerät 3
Geräte 4
Geräte 5
Tabellen $T_{N1}, T_{N2}, T_{N3}, T_{N4}, T_{N5}, T_{N6}, T_{N7}$
Tabellen $T_{N1}, T_{O2}$
Tabellen $T_{N2}, T_{N3}, T_{O3}$
Tabellen $T_{N3}, T_{N4}, T_{N5}, T_{N6}, T_{O4}$
Tabellen $T_{N5}, T_{O5}$
POS $\in$ $T_{N1}$ ODER $T_{N2}$ ODER $T_{N3}$ ODER $T_{N4}$ ODER $T_{N5}$ ODER $T_{N6}$ ODER $T_{N7}$
POS $\in$ $T_{N1}$ ODER $T_{O2}$
POS $\in$ $T_{N2}$ ODER $T_{N3}$ ODER $T_{O3}$
POS $\in$ $T_{N3}$ ODER $T_{N4}$ ODER $T_{N5}$ ODER $T_{N6}$ ODER $T_{O4}$
POS $\in$ $T_{N5}$ ODER $T_{O5}$
nein
nein
nein
ALARM
ALARM
ALARM
ja
ja
ja
ja
ja
if (POS$\in T_{Ni}$) then POS=POS-$S_3$ (i=2,3)
if (POS$\in T_{Ni}$) then POS=POS-$S_4$ (i=3,4,5,6)
if (POS$\in T_{N5}$) then POS=POS-$S_5$
Fertig

FIG. 11

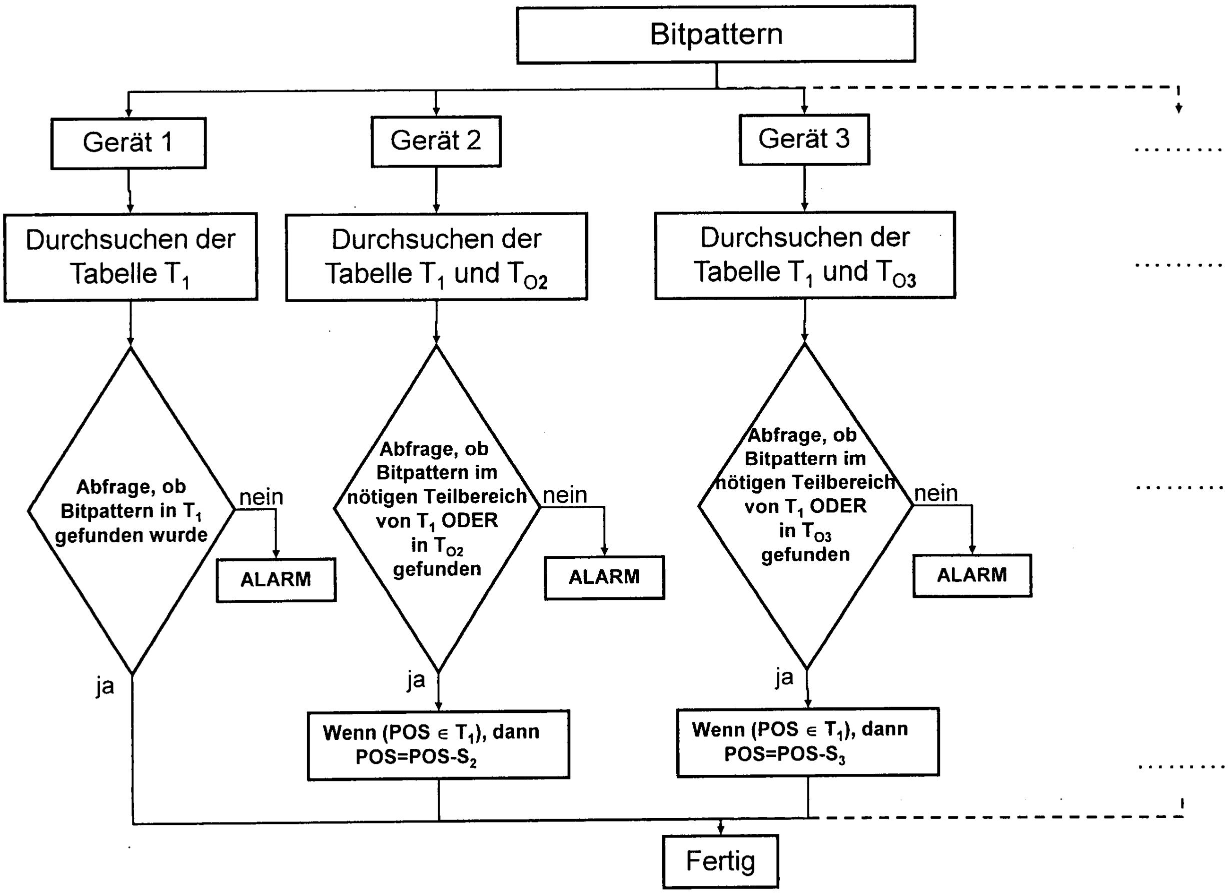
Bitpattern
Gerät 1
Gerät 2
Gerät 3
Durchsuchen der Tabelle $T_1$
Durchsuchen der Tabelle $T_1$ und $T_{O2}$
Durchsuchen der Tabelle $T_1$ und $T_{O3}$
Abfrage, ob Bitpattern in $T_1$ gefunden wurde
Abfrage, ob Bitpattern im nötigen Teilbereich von $T_1$ ODER in $T_{O2}$ gefunden
Abfrage, ob Bitpattern im nötigen Teilbereich von $T_1$ ODER in $T_{O3}$ gefunden
nein
ALARM
nein
ALARM
nein
ALARM
ja
ja
ja
Wenn (POS $\in T_1$), dann POS=POS-$S_2$
Wenn (POS $\in T_1$), dann POS=POS-$S_3$
Fertig

FIG. 12

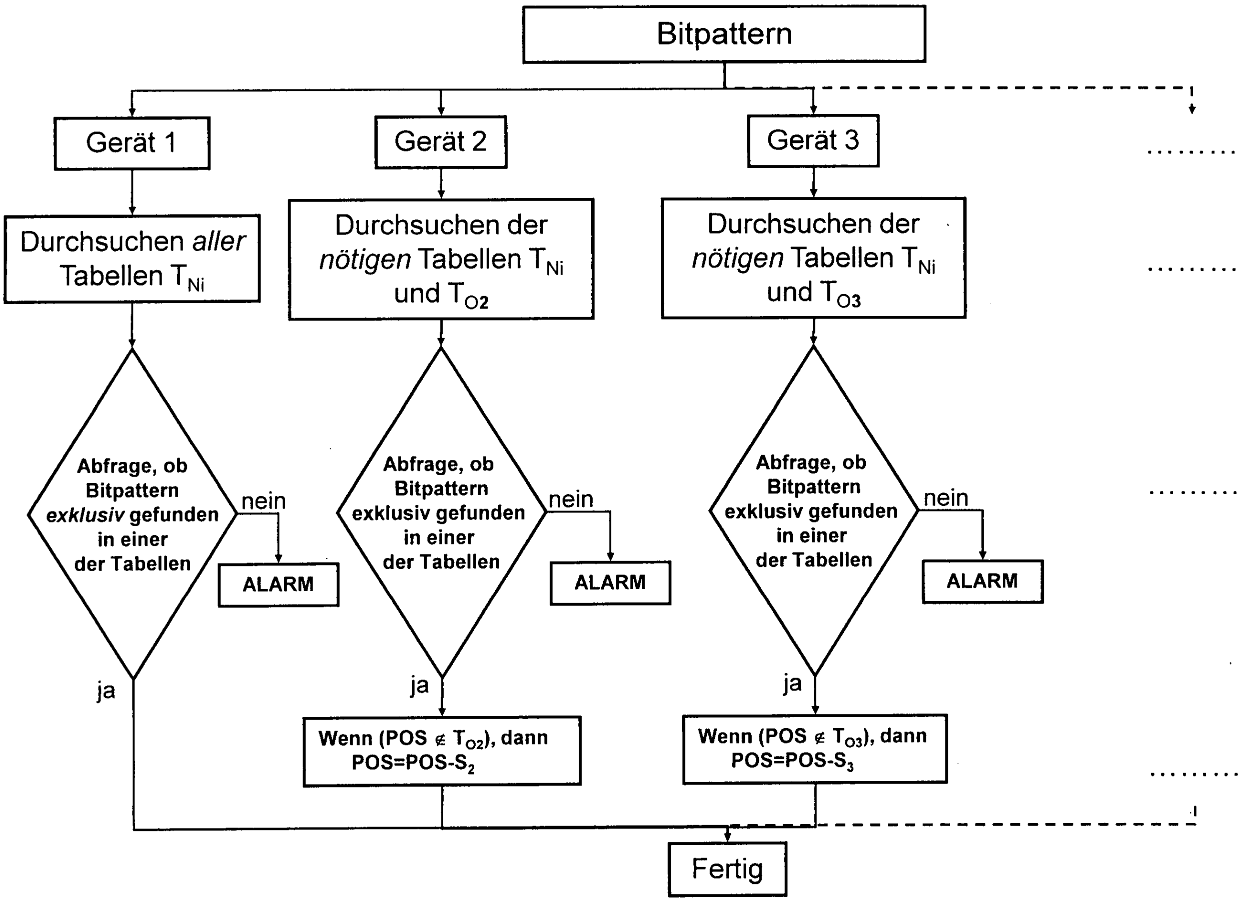
Bitpattern
Gerät 1
Gerät 2
Gerät 3
Durchsuchen *aller* Tabellen $T_{Ni}$
Durchsuchen der *nötigen* Tabellen $T_{Ni}$ und $T_{O2}$
Durchsuchen der *nötigen* Tabellen $T_{Ni}$ und $T_{O3}$
Abfrage, ob Bitpattern *exklusiv* gefunden in einer der Tabellen
Abfrage, ob Bitpattern exklusiv gefunden in einer der Tabellen
Abfrage, ob Bitpattern exklusiv gefunden in einer der Tabellen
nein
nein
nein
ALARM
ALARM
ALARM
ja
ja
ja
Wenn (POS $\notin T_{O2}$), dann POS=POS-$S_2$
Wenn (POS $\notin T_{O3}$), dann POS=POS-$S_3$
Fertig

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- JP 57175211 A
- JP 2005061907 A